Europäisches Patentamt

European Patent Office

Office européen des brevets

(11) Publication number: **0 025 057**
**B1**

# EUROPEAN PATENT SPECIFICATION

(45) Date of publication of patent specification: **13.03.85**

(21) Application number: **80900618.2**

(22) Date of filing: **05.03.80**

(86) International application number:
**PCT/US80/00220**

(87) International publication number:
**WO 80/01967 18.09.80 Gazette 80/21**

(51) Int. Cl.⁴: **H 01 L 23/48, H 01 L 23/24,
B 23 K 20/14, B 23 K 37/04**

(54) THERMO-COMPRESSION BONDING A SEMICONDUCTOR TO STRAIN BUFFER.

(30) Priority: **08.03.79 US 18653**
**09.03.79 US 19224**
**09.03.79 US 19294**

(43) Date of publication of application:
**18.03.81 Bulletin 81/11**

(45) Publication of the grant of the patent:
**13.03.85 Bulletin 85/11**

(84) Designated Contracting States:
**CH DE FR GB SE**

(56) References cited:
**WO-A-79/01012**
**DE-B-1 153 461**
**FR-A-2 263 604**
**GB-A-2 017 408**
**SU-A- 622 603**
**US-A-3 237 272**
**US-A-3 256 598**
**US-A-3 273 029**
**US-A-3 295 089**
**US-A-3 657 611**

(73) Proprietor: **GENERAL ELECTRIC COMPANY
1 River Road
Schenectady New York 12305 (US)**

(72) Inventor: **HOUSTON, Douglas Eugene
7351 Westgate Lane
Liverpool, New York, 13088 (US)**

(74) Representative: **Sieb, Rolf, Dr. et al
Kaiserstrasse 41
D-6000 Frankfurt (Main) 1 (DE)**

(56) References cited:
**US-A-3 726 466**
**US-A-3 761 783**
**US-A-4 005 454**
**US-A-4 046 305**
**US-A-4 071 397**
**US-A-4 089 456**

Courier Press, Leamington Spa, England.

## Description for the Contracting States: DE FR GB SE

This invention relates to a method for thermo-compression diffusion bonding a structured copper strain buffer directly to one or each of the two major opposed surfaces of a substrateless semiconductor device wafer and to a press specifically designed for carrying out this method.

In document WO—A—WO 79/01012 which is published after the priority date of the present application but which is comprised in the state of the art pursuant to Article 54(3) and (4) EPC there is described a method for thermo-compression diffusion bonding a structured copper strain buffer to a substrateless semi-conductor device wafer having two major opposed surfaces, said strain buffer including a bundle of substantially parallel, closely packed strands of copper of substantially equal length, one common end of said strands being thermo-compression diffusion bonded to a metallic sheet comprising the steps of:

applying a first metallic layer to one of said major surfaces;

applying a second metallic layer to said first metallic layer;

positioning the common end of the strands of said strain buffer opposite said metallic sheet in abutment with said second metallic layer;

surrounding the semiconductor device wafer and strain buffer with an inert atmosphere;

applying a loading force to squeeze together at high pressure, said semiconductor device wafer and said strain buffer; and

heating said semiconductor device wafer and said strain buffer at a temperature within the range of 300°C to 400°C while said loading force is applied.

Further is described in WO—A—WO 79/01012 a press for diffusion bonding metallic surfaces of an assembly together comprising a first metallic plate means having a predetermined thermal coefficient of expansion; second metallic plate means having a predetermined thermal coefficient of expansion, said second plate means oriented parallel to said first plate means and spaced apart therefrom so as to accept said assembly between said first and second plate means; and metallic support means connecting said first plate means to said second plate means, said support means having a thermal coefficient of expansion selected to restrict the thermal expansion thereof to a value less than the total thermal expansion in thickness of said first and second plate means when said press is heated to an elevated temperature; whereby equal pressures may be exerted on the metallic surfaces of said assembly to squeeze said surfaces together at high pressure when said press is heated to an elevated temperature.

The invention disclosed in WO—A—WO 79/01012 starts from a prior art where one side of a silicone wafer has been attached to a tungsten disc by a silicon-aluminum braze to provide support for the fragile silicon wafer. Additionally heat sinks, both air cooled and liquid cooled, have been placed on either or both sides of the structure. To obtain good thermal and electrical conductivity between the elements of the device large mechanical presses have been necessary to squeeze the wafer-disc-heat-structure together with several thousand pounds force. Large clamps are required to hold this structure together at this force level, even during device operation. Additionally a characteristic of such devices is that the interfaces between the heat sinks and the silicon wafer are dry. Dry interfaces are those interfaces where one surface is in contact with another but not joined thereto. Consequently the thermal and electrical conductivities across these interfaces are limited. Thus, air and liquid cooled semiconductor devices of the prior art are limited in the amount of power they can handle because of the dry interfaces within the device. Additionally, differential thermal expansion and contraction between the elements of the device with variation of device temperature may cause scrubbing or even cracking of the silicon wafer.

Starting from this prior art it was the object of the invention of WO—A—WO 79/01012 to provide a method for manufacturing a fluid cooled semiconductor device with increased electrical and thermal conductance and reduced stress between the elements thereof, in order to achieve high power operation.

Therefore there is no clear recognition in WO—A—WO 79/01012 of the disadvantage of the substrate used in the prior art as evidenced by the main method claim no. 20 and the respective Fig. 11 of said document using a support member 66. All the expert can take from said document is, that dry interfaces between the various parts are to be avoided but not that the substrates of the prior art are to be avoided.

Also in document WO—A—WO 79/01012 the lateral extent of the strain buffers is always less than the lateral extent of the respective semiconductor device wafer surface in contract therewith.

DE—B—1 153 461 which is published before the priority date of the present application describes a semiconductor device corresponding to the prior art as already discussed above in connection with document WO—A—WO 79/01012 for said semiconductor device of said German reference necessarily includes a substrate and additionally the copper strand bundle is not diffusion bonded but soldered.

In the pre-published US—A—4 046 305 there is described a press for diffusion bonding metallic surfaces of an assembly together, comprising a first metallic plate means having a predetermined thermal coefficient of expansion, second metallic plate means having a predetermined thermal coefficient of expansion, said second plate means oriented parallel to said first plate means and spaced apart therefrom so as to accept said assembly between said first and second plate means, and metallic support means connecting said first plate means to said second plate means, said support means having a thermal coefficient of expansion selected to restrict the thermal expansion thereof to a value less than the total thermal expansion in thickness of said first and second plate means when said press is heated to an elevated temperature, whereby equal pressures may be exerted on the metallic surfaces of said assembly to squeeze said surfaces together at high pressure when said press is heated to an elevated temperature.

When attaching heat sinks to the respective opposed surfaces of a semiconductor device wafer, it is often desirable that these attachments occur as close to the semiconductor device wafer as possible in order to optimize heat removal from the wafer. Such is the case when heat sinks are attached via respective structured copper strain buffers to a semiconductor device wafer. Briefly, a structured copper strain buffer comprises a bundle of substantially parallel, closely packed strands of copper of substantially equal length, one common end thereof being thermo-compression diffusion bonded to a metallic sheet.

One type of prior high power semiconductor device includes a metallic support plate or substrate, typically comprised of tungsten or molybdenum, attached to one of the opposed surfaces of a semiconductor device wafer to provide the inherently fragile wafer with structural integrity. In those devices, heat sinks have been attached via structured copper strain buffers to one or both sides of the wafer support plate structures.

It is desirable, however, to diffusion bond respective heat sinks via structured copper strain buffers "directly" to each of the opposed surfaces of a semiconductor device wafer, thereby eliminating the rather expensive metallic support plate and simultaneously providing heat sinks attached to the strain buffers with a more intimate thermal connection to the semiconductor device wafer. More efficient heat conduction away from the wafer results. The term "directly" as used herein signifies that actually such bonds are made to the metallized layers situated on the respective major opposed surface of the wafer, and not to the wafer itself.

Brief summary of the invention

The present invention is directed to increasing the conduction of heat away from a semiconductor device wafer having respective structured copper strain buffers diffusion bonded to one or each of the two major surfaces thereof. The support plate attached to the semiconductor device wafer as needed in many conventional semiconductor device structures is not required and respective structured copper strain buffers are thermo-compression diffusion bonded "directly" to one or each of the two major surfaces of the wafer.

In accordance with one preferred embodiment of the invention, an improved press for diffusion bonding metal surfaces of an assembly together comprises a first metallic plate means having a predetermined thermal coefficient of expansion; second metallic plate means having a predetermined thermal coefficient of expansion, said second plate means oriented parallel to said first plate means and spaced apart therefrom so as to accept said assembly between said first and second plate means; and metallic support means connecting said first plate means to said second plate means, said support means having a thermal coefficient of expansion selected to restrict the thermal expansion thereof to a value less than the total thermal expansion in thickness of said first and second plate means when said press is heated to an elevated temperature, whereby equal pressures may be exerted on the metallic surfaces of said assembly to squeeze said surfaces together at high pressure when said press is heated to an elevated temperature, first and second expansion blocks facing each other and attached, respectively, to said first and second plates, said first and second expansion blocks, respectively, including first and second raised portions extending towards each other, each raised portion including a flat surface having a selected geometric pattern, the geometric patterns of said first and second raised portions being substantially identical and axially and rotationally aligned with each other, each said flat surface being substantially parallel to the other.

In accordance with another preferred embodiment of the invention, a method for thermo-compression diffusion bonding a structured copper strain buffer to a substrateless semiconductor device wafer having two major opposed surfaces, said strain buffer including a bundle of substantially parallel, closely packed strands of copper of substantially equal length, one common end of said strands being thermo-compression diffusion bonded to a metallic sheet, comprises the steps of applying a first metallic layer to one of said major surfaces; applying a second metallic layer to said first metallic layer; positioning the common end of the strands of said strain buffer, having a lateral extent at least equal to that of said wafer surfaces, opposite said metallic sheet in abutment with said second metallic layer; surrounding the semiconductor device wafer and strain buffer with an inert atmosphere; applying a loading force to squeeze together at high pressure, said semiconductor device wafer and said strain buffer; and heating said semiconductor device wafer and said strain buffer at a temperature within the range of 300°C to 400°C while said loading force is applied.

In accordance with another preferred embodiment of the invention, a method is provided for thermo-compression diffusion bonding first and second structured copper strain buffers to a substrateless semi-conductor device wafer having first and second opposed surfaces of unequal lateral extents and a beveled outer edge surface. The beveled surface is cleaned to remove contaminants therefrom and then coated with a passivation material. The semiconductor device wafer with the above-described metallic layers and metallizations disposed thereon is sandwiched between the first and second structured copper strain buffers. Each of these strain buffers is of lateral extent at least equal to the lateral extent of the respective semiconductor device wafer surface in contact therewith such that the beveled edge surface either remains uncovered or covered by either of the structured copper strain buffers. When the lateral extent of the strain buffer is greater than the lateral extent of the wafer, the strain buffer is positioned so as to overhand the entire outer edge surface of the wafer. Each structured copper strain buffer is positioned such that the common end of the copper strands opposite the metallic sheet thereof faces the semiconductor device wafer. The so-positioned semiconductor device wafer structure and structured copper strain buffers are surrounded by an inert atmosphere. A loading force is applied to identical, axially aligned portions of the first and second strain buffers, respectively, to squeeze them together at high pressure and, at the same time, the so-positioned semiconductor device wafer and structured copper strain buffers are heated at a temperature within the range of 300°C to 400°C. Thermocompression diffusion bonds are thus formed between the two major, opposed metal-coated surfaces of a substrateless, beveled semiconductor device wafer and respective first and second structured copper strain buffers, without wafer fracture.

In an alternative embodiment of the invention, first and second structured copper strain buffers are thermo-compression diffusion bonded to each of the two metallized major surfaces of a semiconductor device wafer. The outer edge surface of the semiconductor device wafer is beveled preferably prior to sandwiching the semiconductor device wafer between the first and second structured copper strain buffers. The separate metallic layers and metallizations are applied to each of the opposed surfaces of the semiconductor device wafer as previously set forth, but with the metallic layers and metallizations having a lateral extent sufficiently small to avoid overlapping the beveled surface. The metallic layer and metallization on the surface of the wafer which is beveled are axially aligned with each other and with the metallic layer and metallization on the opposite surface of the wafer, which likewise are axially aligned with each other. All metallic layers and metallizations are formed with an equal lateral extent. The semi-conductor device wafer is then sandwiched between the first and second strain buffers and the semiconductor device wafer and first and second structured copper strain buffers are squeezed together while being heated in an inert atmosphere, as described above. The metallic sheet of the first structured copper strain buffer is thereafter cut, preferably with a laser beam to remove the portion so the first strain buffer not bonded to the semiconductor device wafer. The beveled edge surface of the wafer is cleaned, typically by sputter etching, and is then passivated. Thermo-compression diffusion bonds are thus formed between the two major opposed surfaces of the beveled semiconductor device wafer and respective first and second structured copper strain buffers without wafer fracture.

The invention may best be understood by reference to the following description taken in conjunction with the accompanying drawings.

Figure 1 is a cross-sectional side view of a thermo-compression diffusion bonding press showing materials situated in the press to be bonded together in practicing the invention.

Figure 2 illustrates the diffusion bonding press of Figure 1 with a layer of compactible material situated between a metallic pressing block and a structured copper strain buffer to avoid the undesirable bonding of the pressing block to the strain buffer in accordance with the invention.

Figure 3 is a cross-sectional view of a beveled semiconductor device with structured copper strain buffers having a lateral extent greater than the lateral extent of the wafer thermo-compression diffusion bonded to each of the opposed surfaces of the wafer.

Figure 4 illustrates laser cutting of a portion of a structured copper strain buffer in preparation for passivating the semiconductor device wafer diffusion bonded thereto.

Figure 5 is a top view of the bonded semi-conductor device wafer-strain buffer structure shown in Figure 4 after removal of the portions of the strain buffer cut away by the laser.

Figure 6 is a cross-sectional side view of the wafer-strain buffer structure shown in Figure 5, after passivation.

Figure 7 is a cross-sectional view of a beveled semiconductor device wafer with structured copper strain buffers having a lateral extent greater than the lateral extent of the wafer thermo-compression diffusion bonded to each of the metal-coated, opposed surfaces of the wafer.

Figure 8 is a cross-sectional side view of an improved thermo-compression diffusion bonding press showing materials situated therein to be bonded together.

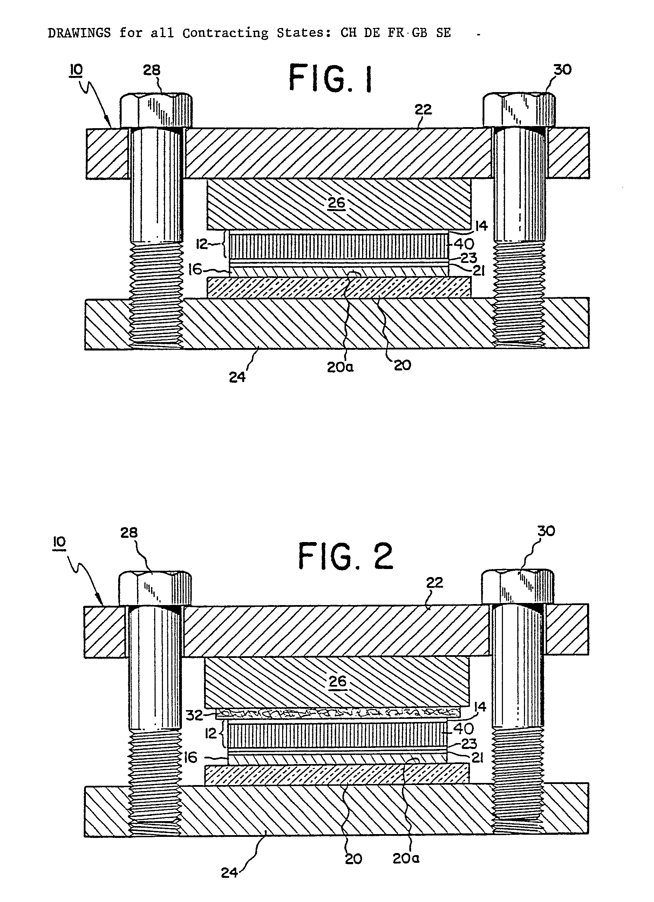

Figure 1 shows a diffusion bonding press 10 which may be used in thermo-compression diffusion bonding a structured copper strain buffer 12 directly to a substrateless semiconductor device wafer 16. Press 10 is comprised of an upper metallic plate 22 oriented parallel to a lower metallic plate 24 with a spaced provided therebetween. A metallic pressing block 26 is positioned at the center of the side of upper plate 22 facing lower plate 24. Metallic bolts 28 and 30 pass through respective holes in upper plate 22 and lower plate 24 and are threaded into lower plate 24 to connect the two plates together as illustrated in Figure 1.

Metallic bolts 28 and 30 are comprised of a steel other than stainless steel, while upper plate 22, lower plate 24 and metallic pressing block 26 are comprised of stainless steel. Metallic pressing block 26 may alternatively be comprised of Dural, an aluminum alloy, or other metals having a coefficient of thermal expansion greater than that of steel.

To achieve a thermo-compression diffusion bond between structured copper strain buffer 12 and semiconductor device wafer 16, a disk of rigid material 20 having a flat reference surface 20a is situated within press 10 on lower plate 24. Member 20 is comprised of a rigid material such as quartz, for example, which will withstand high pressures of 1380 to 3450 bar without measurably yielding.

Each of the opposed major surfaces of semiconductor device wafer 16 is smoothened to removed surface damage therefrom. Such surface damage would otherwise cause nonuniform distribution of pressures within wafer 16 and, thus, wafer breakage when the wafer is subjected to the high pressure employed in the thermo-compression diffusion bonding process of the invention. This step of smoothing may be accomplished, for example, by polishing or etching each of the opposed major surfaces.

One of the two major opposed surfaces of wafer 16 is provided with a first metallic layer 21, comprised of one of such metals as titanium, chromium and nickel, coated thereon. A second metallic layer 23 comprised of one of such metals as copper, silver and gold is applied over the metallic layer 21. Metallic layers 21 and 23 may be applied to wafer 16 by sputtering or evaporation, for example.

Structures to be diffusion bonded together are situated upon surface 20a of member 20. Specifically, wafer 16 is situated on surface 20a with the uncoated surface of wafer 16 positioned facing surface 20a.

Structured copper strain buffer 12 is positioned in abutment with the exposed surface of metallic layer 23 on wafer 16. Strain buffer 12 comprises a bundle of substantially parallel, close-packed strands of copper 40 of substantially equal length, one common end thereof being thermo-compression diffusion bonded onto a metallic sheet 14, typically comprised of copper. The remaining common end of strands 40 is situated in abutment with metallic layer 23 on wafer 16. A conventional press (not shown) is used to squeeze upper plate 22 and lower plate 24 together and while such pressure is applied to these plates, bolts 28 and 30 are tightened.

The thermo-compression diffusion bond between structured copper strain buffer 12 and semiconductor device wafer 16 is actually formed when press 10 containing rigid member 20, semiconductor device wafer 16 with metallic layers 21 and 23 disposed thereon and structured copper strain buffer 12, positioned as described above and as shown in Figure 1, are placed in an inert atmosphere and heated at a temperature within the range of 300°C. to 400°C., typically 325°C., for approximately 15 minutes to 5 hours. When press 10 is heated in this manner, upper plate 22, lower plate 24, and metallic pressing block 26 expand to a greater total extent than do metallic bolts 28 and 30. Therefore, a force is exerted between pressing block 26 and lower plate 24 resulting in the squeezing of structured copper strain buffer 12 and semiconductor device wafer 16 together and the thermo-compression diffusion bonding of each to the other. Although frequent reference is made herein to the thermo-compression diffusion bonding of structured copper strain buffer 12 to semiconductor device wafer 16 for simplicity of description, those skilled in the art will appreciate that the thermo-compression diffusion bond is actually formed between the common end of copper strands 40 opposite metallic sheet 14 and metallic layer 23 on wafer 16.

During thermo-compression diffusion bonding, semiconductor device wafer 16, is subjected to high pressure, specifically, 1380 to 3450 bar. If this force is not purely compressive, that is, if semiconductor device wafer 16 is subjected to bowing or tensile forces, wafer 16 will likely fracture, resulting in a damaged semiconductor device. It is thus extremely important that uniform high pressure be applied over the entire wafer 16. The surfaces of the members to be bonded together must be flat and parallel to each other and to the opposed, facing surfaces of lower plate 24 and metallic pressing block 26. Situating rigid member 20 on lower plate 24 provides an essentially non-yielding, flat reference surface for semiconductor device wafer 16 placed thereon. Employing rigid member 20 in this manner assures that semiconductor device wafer 16 is subjected to substantially pure compressive forces during thermo-compression diffusion bonding, with negligible tensile forces being exerted on the wafer, enabling the diffusion bond to be achieved without fracture of the substrateless wafer. The resulting bonded semiconductor device wafer-strain buffer-heat sink assembly includes no substrate or support plate. Heat is conducted more efficiently away from the wafer to the heat sink than if the assembly were to include such substrate.

Figure 2 is identical to Figure 1 with like numerals signifying like components, except for the placement of a layer 32 of nonreactive compactible material between pressing block 26 and strain buffer 12. In accordance with the preferred embodiment of the invention, layer 32 is so positioned prior to application of the loading force discussed in the method set forth above. Such layer of compactible material tends to compress under application of the loading force, filling in any irregularities in the facing surface of metallic sheet 14 and resulting in a more uniform distribution of the loading force on strain buffer 12. The thermo-compression diffusion bond between strain buffer 12 and wafer 16 is thus made substantially void free. Layer 32 additionally prevents strain buffer 12 from undesirably adhering to metallic pressing block 26 during thermo-compression diffusion bonding. Layer 32 may be comprised of glass wood, or Glass Fiber Filter paper available from Fisher Scientific Company, Clifton, New Jersey, or other similarly compactible materials.

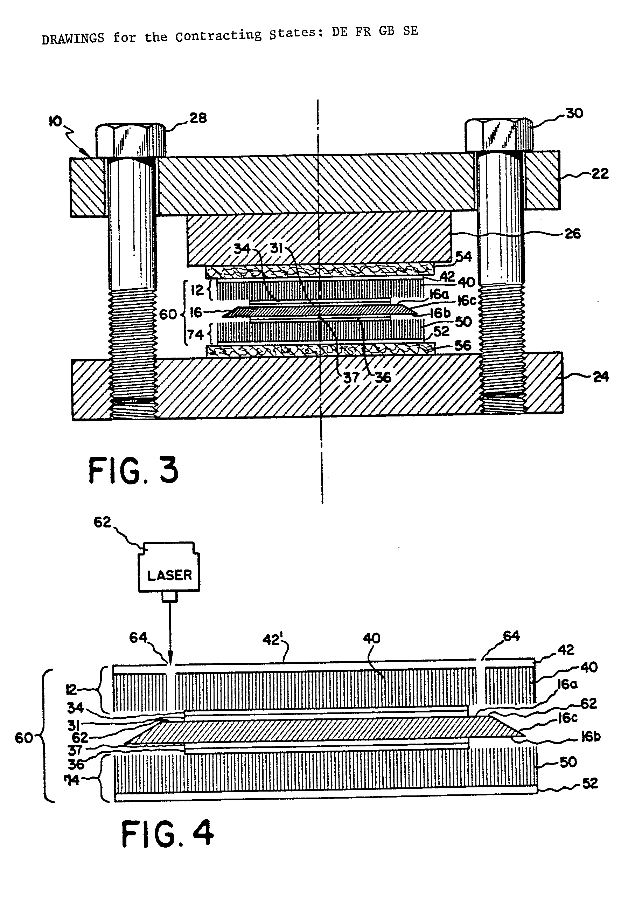

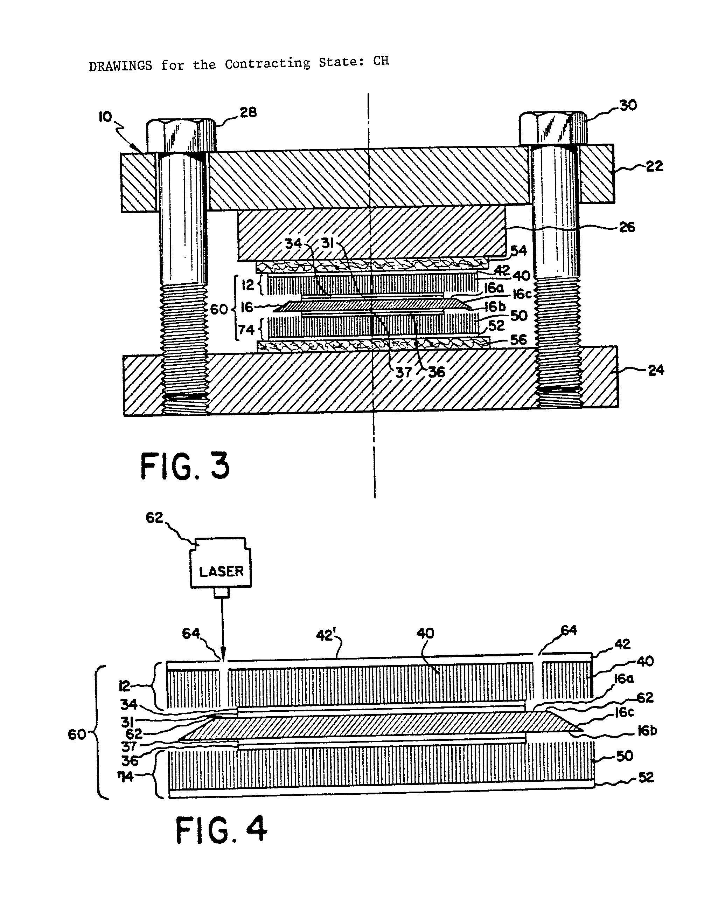

Figure 3 shows a diffusion bonding press 10 suitable for thermo-compression diffusion bonding a first structured copper strain buffer 12 and a second structured copper strain buffer 74, respectively, to the opposed major surfaces 16a and 16b of substrateless semiconductor device wafer 16. The outer edge surface 16c of semiconductor device wafer 16 is preferably beveled, as shown in Figure 3, although the invention encompasses wafers both with and without a beveled outer edge surface.

To achieve the respective thermo-compression diffusion bonds between strain buffers 12 and 74 and wafer 16, surfaces 16a and 16b are smoothened to remove surface damage therefrom. Such surface damage would otherwise cause nonuniform distribution of pressures within wafer 16 and thus wafer breakage when wafer 16 is subjected to the high pressures employed in the thermo-compression diffusion bonding process of the invention. This step of smoothing may be accomplished, for example, by polishing or etching surfaces 16a and 16b.

Metallic layers 31 and 37 are applied to wafer surfaces 16a and 16b, respectively. Each of metallic layers 31 and 37 is comprised of one of such metals as titanium, chromium and nickel. Metallizations 34 and 36 are respectively applied over metallic layers 31 and 37. Each metallizations 34 and 36 are respectively comprised of one of such metals as copper, gold and silver. These metallic layers and metallizations may be applied to wafer 16 by sputtering or evaporation, for example.

The wafer-metallic layer-metallization structure thus formed is sandwiched between structured copper strain buffers 12 and 74. Structured copper strain buffer 12 is comprised of a bundle of substantially parallel,

closely packed strands of copper 40 of substantially equal length with one common end thereof thermo-compression diffusion bonded to a metallic sheet 42, typically comprised of copper. The opposite common end of copper strands 40 is positioned in abutment with metallization 34. Structured copper strain buffer 74 is essentially identical to structured copper strain buffer 12 and is comprised of copper strands 50 and metallic sheet 52. The common end of copper strands 50 opposite metallic sheet 52 is positioned in abutment with metallization 36.

A layer 54 of nonreactive compactible material is situated in abutment with metallic sheet 42 of structured copper strain buffer 12. Layer 54 may be comprised of glass wood or Glass Fiber Filter paper available from Fisher Scientific Company, Clifton, New Jersey, or other similarly compactible material. A layer of compactible material 56 preferably comprised of the same material as layer 54 is positioned in abutment with metallic sheet 52 of structured copper strain buffer 74.

The combined structure formed by semiconductor device wafer 16, structured copper strain buffers 12 and 74, and metallic layers 31 and 37 and metallizations 34 and 36 disposed therebetween and compactible layers 54 and 56 is positioned in press 10 between pressing block 26 and lower plate 24. A conventional press (not shown) is used to squeeze upper plate 22 and lower plate 24 together and while such pressure is applied to these plates, bolts 28 and 30 are tightened.

The thermo-compression diffusion bonds between structured copper strain buffer 12 and wafer 16, and between structured copper strain buffer 74 and wafer 16 are actually formed when press 10 containing the above-described combined structure, illustrated in Figure 1, is surrounded by an inert atmosphere and heated at a temperature within the range of 300°C. to 400°C., typically 325°C., for approximately 15 minutes to 5 hours. When press 10 is heated in this manner, upper plate 22, lower plate 24 and metallic pressing block 36 expand to a greater total extent than do metallic bolts 28 and 30. Therefore, a force is exerted between pressing block 26 and lower plate 24, resulting in the squeezing of structured copper strain buffers 12 and 74 and semiconductor device wafer 16 together and the thermo-compression diffusion bonding of buffers 12 and 74 to wafer 16. The now-formed strain buffer-wave assembly 60 is removed from press 10 by loosening bolts 28 and 30. Although reference is made herein to the thermo-compression diffusion bonding of strain buffer 12 to wafer 16 and strain buffer 74 to wafer 16 for simplicity of description, those skilled in the art will appreciate that the actual thermo-compression diffusion bonds are formed at the interface between the common end of copper strands 40 and metallization 34, and at the interface between the common end of copper strands 50 and metallization 36.

During thermo-compression diffusion bonding, substrateless semiconductor device wafer 16 is subjected to high pressures, specifically, 1380 to 3450 bar. If this force is not purely compressive, that is, if semiconductor device wafer 16 is subjected to bowing or tensile forces, wafer 16 will likely fracture, resulting in a damaged semiconductor device. It is thus extremely important that uniform high pressure be applied over the entire wafer 16.

Prior methods of thermo-compression diffusion bonding used a support plate attached to the semiconductor device wafer to enable the wafer to withstand some degree of bowing forces and nonuniform pressure without fracture. When attempting thermo-compression diffusion bonding of members to a "substrateless" semiconductor device wafer, it is important that the surfaces of the members to be bonded together be flat and parallel to each other and to the opposed facing surfaces of lower plate 24 and metallic pressing block 26. To solve the problem of bowing forces being generated near the edge surface of wafer 16 during thermo-compression diffusion bonding as would occur if strain buffers 12 and 74 did not extend over the entire lateral extent of wafer 16, the lateral extent of structured copper strain buffers 12 and 74 is made greater than the lateral extent of wafer 16 such that buffers 12 and 74 overhang wafer 16 around the entirety of its edge surface.

Layers of compactible material 54 and 56 are positioned as described above to assure that during thermo-compression diffusion bonding, structured copper strain buffer 12 does not adhere undesirably to pressing block 26 and to assure that structured copper strain buffer 74 similarly does not bond to lower plate 24. Use of such layers of compactible material helps assure the creation of uniform, substantially void-free diffusion bonds. Voids in diffusion bonds may result when a thermo-compression diffusion bond between a compliant metallic member (such as a structured copper strain buffer) and another member having some degree of surface irregularity is attempted. When compressed, the layers of compactible material fill in the irregularities in the surface of the respective structured copper strain buffers allowing the diffusion bonding press 10 to apply a more evenly distributed pressure to the members which are to be bonded together. Use of layers of compactible material 54 and 56 is preferable but not essential to practice of the method of the invention.

If semiconductor device wafer 16 is of the nonbeveled variety, no further processing in accordance with the invention is required. However, if wafer 16 includes a beveled outer edge surface 16c, as illustrated, it is desirable that surface 16c be cleaned and passivated to protect it from external contamination. As shown in Figure 4, beveled edge surface 16c lies recessed under structured copper strain buffer 12 and is thus inaccessible for cleaning and passivation purposes. It would be undesirable to passivate beveled surface 16c prior to thermo-compression diffusion bonding since the additional thickness of the passivant, which would likely become affixed to the outer edge of wafer surfaces 16a and 16b would cause uneven pressure on the wafer during such diffusion bonding and likely result in fracturing the wafer. Therefore, passivation of beveled surface 16c is achieved in the following manner. Prior to sandwiching wafer 16 between structured copper strain buffers 12 and 74, metallic layers 31 and 37, applied to major surfaces 16a and 16b, respectively, of wafer 16, are formed with a lateral extent sufficiently small so as to avoid overlapping beveled surface 16c. That is, the lateral extent of layers 31 and 37 may be equal to or less than the lateral extent of surface 16a. Metallizations 34 and 36 are thereafter applied over metallic layers 31 and 37, respectively, with lateral extents equal to those of metallic layers 31 and 37, all of the above-mentioned lateral extents being equal and axially aligned with each other, as shown in Figure 4.

When the thermo-compression diffusion bonding process is carried out upon the metallized wafer structure 16, the common end of copper strands 40 opposite metallic sheet 42 of strain buffer 12 becomes thermo-compression diffusion bonded only to the metallized portions of surface 16a. Similarly, the common end of copper strands 50 opposite metallic sheet 52 of strain buffer 74 diffusion bonds only to metallized portions of surface 16b.

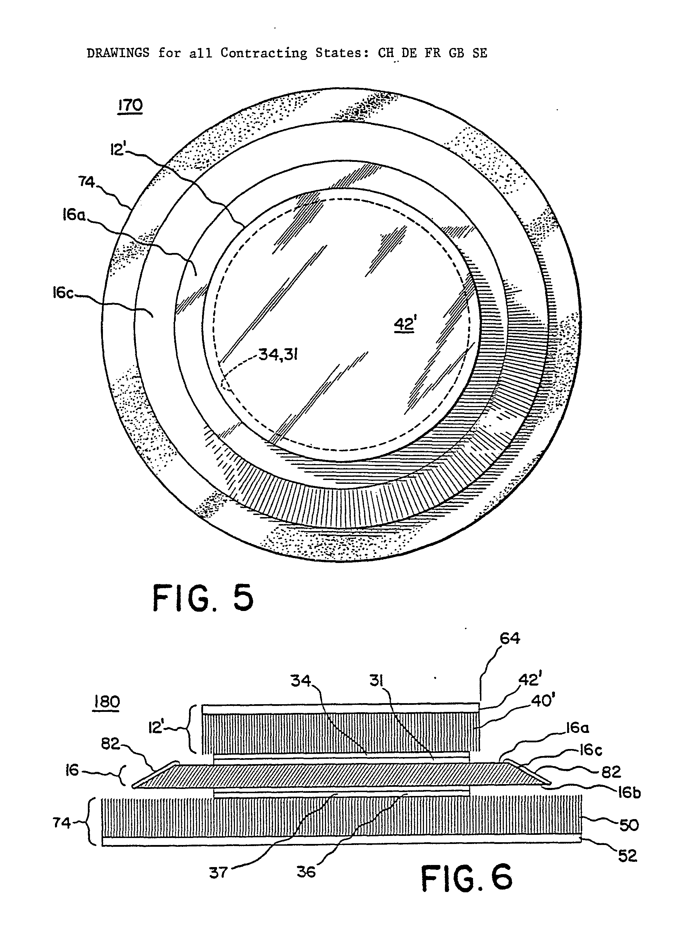

A laser device 62 such as a pulsed laser, typically having a peak pulsed power of 16 KW although not limited thereto, generates a beam of coherent light which is directed along a selected path on metallic sheet 42 of strain buffer wafer assembly 60, fabricated as previously described, so as to form an incision 64 in sheet 42 and thus allow the removal of most of the portion of strain buffer 12 not bonded to wafer metallization 34. The portion of structured copper strain buffer 12 outside incision 64 is removed to form wafer-buffer structure 170 shown in Figure 5. The remaining portion of strain buffer 12 is designated strain buffer 12'. Beveled edge surface 16c is thus made accessible for cleaning and passivation.

Chemically etching the surface of a beveled semiconductor device wafer is a method for wafer cleaning well known in the art. However, such an etching step, if applied to wafer-buffer structure 170 would result in the undesirable chemical attack of the structured copper strain buffers 12 and 74 by the etchant. Rather, beveled surface 16c is subjected to sputter etching to remove contaminants therefrom prior to passivation.

Subsequently, beveled surface 16c is coated with a passivation layer 82 comprised of one of the many passivation materials known in the art, polyimide siloxane, for example, as illustrated in Figure 6.

To complete the device thus formed, heat sinks (not shown) are respectively attached to metallic layers 42 and 52 of strain buffers 12' and 74. This is preferably accomplished by thermo-compression diffusion bonding during the course of attachment of strain buffers 12 and 74 to wafer 16 or at a later time. Although heat sink attachment may be accomplished by other means of joining metals together, soldering, for example, thermo-compression diffusion bonding is preferred because it inherently achieves superior thermal conductivity between the joined metallic members.

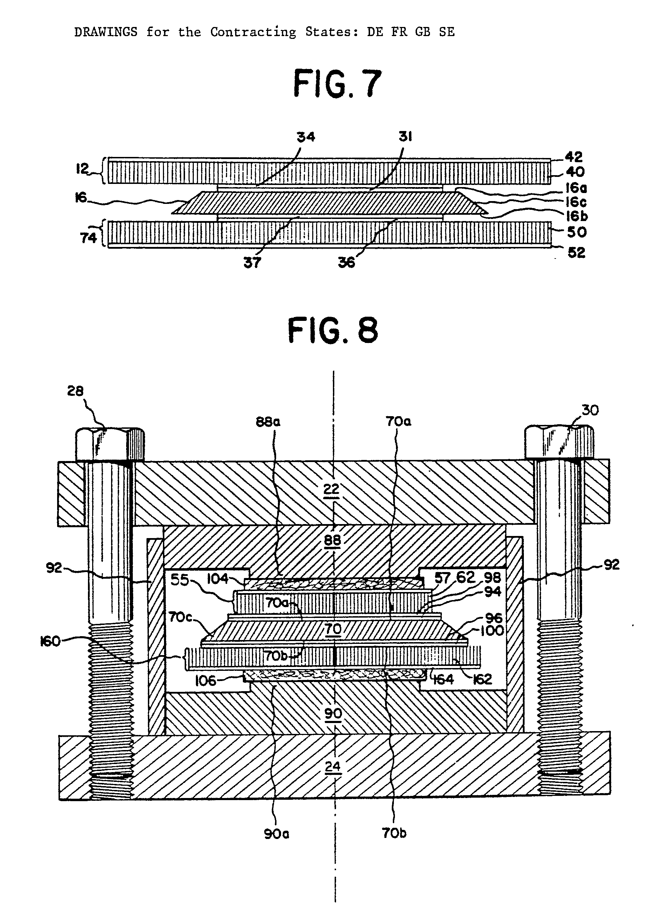

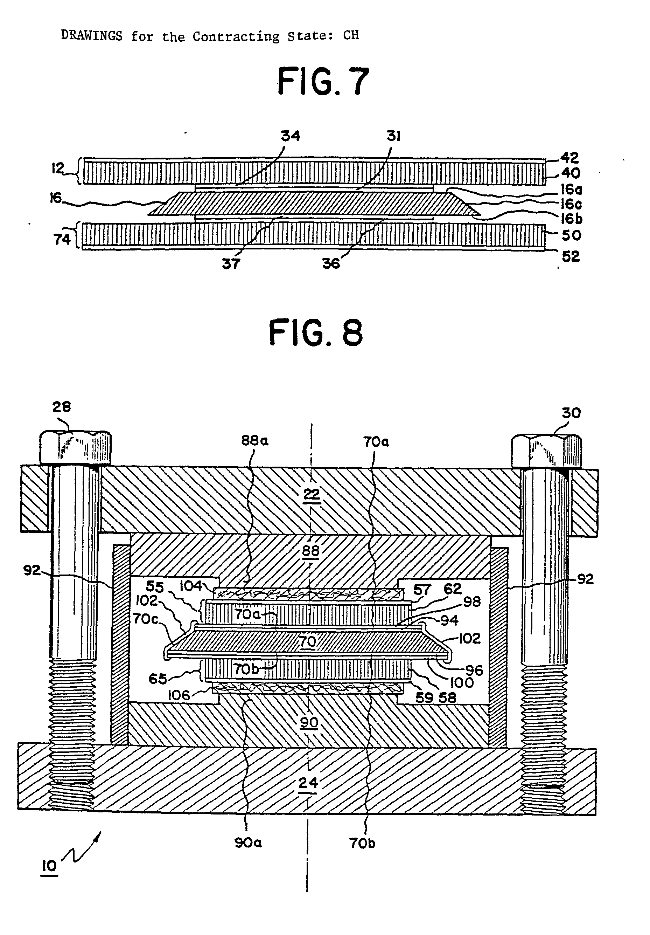

Thermo-compression diffusion bonding of the above method results in the intermediate structure shown in Figure 7 wherein a semiconductor device wafer 16 includes opposed major surfaces 16a and 16b and beveled edge surface 16c. First and second metallic layers 31 and 37 are coated respectively on surfaces 10a and 10b. Metallizations 34 and 36 are coated, respectively, on metallic layers 31 and 37. Structured copper strain buffers 12 and 74 are thermo-compression diffusion bonded respectively to metallizations 34 and 36. Structured copper strain buffer 12 includes a bundle of substantially parallel closely packed strands of copper 40, one common end thereof thermocompression diffusion bonded into a metallic sheet 42. Structured copper strain buffer 74 is substantially similar to strain buffer 12 and includes copper strands 50 and metallic sheet 52. As pointed out above, structured copper strain buffers 12 and 74 are formed in such a manner as to have a lateral extent greater than that of silicon wafer 16, so as to prevent the silicon wafer 16 from being subjected to bowing forces which cause wafer fracture. Bowing forces are thus substantially eliminated; however, this bonding method essentially prohibits cleaning and passivating beveled surface 16c prior to bonding because of the high probability that passivant applied to surface 16c would flow onto portions of surfaces 16a and 16b, causing wafer 16 to experience bowing forces and nonuniform pressure when thermocompression diffusion bonding is attempted. To allow passivation of the beveled edge 16c therefore, a laser beam is used to cut away the portion of structured copper strain buffer 12 overhanging beveled surface 16c. Beveled surface 16c is thereby exposed for cleaning, preferably via sputter etching, and passivating. Conventional economical chemical etching is not a preferable method for cleaning beveled surface 10c because the etchant would chemically attack the structured copper strain buffers 12 and 74.

This embodiment constitutes an alternative solution to the problem of preventing bowing forces when thermo-compression diffusion bonding structured copper strain buffers to a substrateless semiconductor device wafer. One embodiment of the invention desirably allows cleaning of the beveled surface via conventional chemical etching and passivation prior to diffusion bonding.

As illustrated in Figure 8, a press apparatus is provided to bond first and second structured copper strain buffers 55 and 160, respectively, to the opposed major surfaces 70a and 70b of substrateless semiconductor device wafer 70. The structured copper strain buffer 160 is an "oversized" one, that is, a strain buffer having a lateral extent greater than the larger major surface of substrateless wafer 70. The outer edge 70c of semiconductor device wafer 70 is beveled as shown in Figure 8.

The bonding press includes an upper metallic plate 22 oriented parallel to a lower metallic plate 24 with a space provided therebetween. Metallic bolts 28 and 30 pass through respective holes in upper plate 22 and lower plate 24 and are threaded into lower plate 24 to connect the two plates together as illustrated in Figure 8. A metallic pressing block (or expansion block) 88 is positioned at the center of the lower surface of upper plate 22 and attached thereto. A similar metallic pressing block (or expansion block) 90 is positioned at the center of the upper surface of lower plate 24 and attached thereto. Pressing blocks 88 and 90 each include raised portions 88a and 90a respectively extending therefrom and facing each other. Raised portion 88a has a flat surface of a selected geometric pattern, circular, square, rectangular or various other polygons, for example, which is axially and rotationally aligned with a like flat surface of identical geometric pattern on raised portion 90a. The flat surfaces of raised portions 88a and 90a are parallel to each other. Raised portions 88a and 90a are held in alignment by a guide member 92 positioned in abutment with pressing blocks 88 and 90. Guide member 92 is conveniently of cylindrical shape having an inner diameter sufficiently large to accommodate the maximum lateral extent of pressing blocks 88 and 90 therein.

Metallic pressing blocks 88 and 90 are comprised of a metal having a thermal coefficient of expansion greater than that of metallic bolts 28 and 30. For example, pressing blocks 88 and 90 may be comprised of such metals as stainless steel, Dural and other aluminum alloys. Guide member 92 is comprised of a material having a thermal coefficient of expansion equal to or greater than that of pressing blocks 88 and 90.

To achieve the respective thermo-compression diffusion bonds between strain buffers 55 and 160 and wafer 70, surfaces 70a and 70b are smoothened to remove surface damage therefrom. Such surface damage would otherwise cause nonuniform distribution of pressures within wafer 70 and thus wafer fracture when wafer 70 is subjected to the high pressures employed in the thermo-compression diffusion bonding process of the invention. Metallic layers 94 and 96 are then applied to surfaces 70a and 70b, respectively. Each of metallic layers 94 and 96 are comprised of one of such metals as titanium, chromium and nickel. Metallizations 98 and 100 are respectively applied over metallic layers 94 and 96 and are comprised of such metals as copper, silver and gold. Beveled surface 70c may then be cleaned to remove contaminants therefrom, although it is preferred to clean it later, as explained below. A chemical etch may be used to perform this cleaning since at this juncture the structure copper strain buffers are not yet bonded to wafer 70 and thus there is no opportunity for the etch to chemically attack the structured copper strain buffers. Alternately, sputter etching may be used to clean beveled surface 70c. After being cleaned, beveled surface 70c may be coated with a passivation material such as polyimide siloxane for example. Said passivation material may partially extend on to major surfaces 70a and 70b without causing the undesirable generation of bowing forces in wafer 16 during subsequent thermo-compression diffusion bonding.

The wafer-metallic-layer-metallization-passivation assembly thus formed is sandwiched between structured copper strain buffers 55 and 160. Structured copper strain buffer 55 is comprised of a bundle of substantially parallel, closely packed strands of copper 62 of substantially equal length with one common end thereof being thermo-compression diffusion bonded to a metallic sheet 57. The opposite common end of copper strands 62 is positioned in abutment with metallization 98. Structured copper strain buffer 160 has a greater lateral extent than structured copper buffer 55 and is comprised of copper strands 162 and metallic sheet 164. The common end of copper strands 162 opposite metallic sheet 164 is positioned in abutment with metallization 100. Strain buffer 55 has a lateral extent less than the lateral extent of the respective wafer 70 surface in contact therewith such that beveled surface 70c remains uncovered by said strain buffer. Additionally, the lateral extent of strain buffer 55 is sufficiently small such that buffer 55 does not overlap any passivation material which may be present on wafer surface 70a. If such overlap were occur, undesirable bowing forces would likely result.

Therefore, where an "oversized" strain buffer like 160 is employed beveled surface 70c is cleaned and passivated only after the desired thermo-compression diffusion bonds have been formed, preventing passivation material intended for beveled surface 70c from coating portions of major surfaces 70a and 70b near beveled surface 70c before bonding and thereby creating an irregularity in these major surfaces which might result in generation of some unacceptable bowing force during thermo-compression diffusion bonding and consequential wafer fracture.

A layer 104 of nonreactive, compactible material is situated in abutment with metallic sheet 57 of structured copper strain buffer 55. Layer 104 may be comprised of glass wool or Glass Fiber Filter paper available from Fisher Scientific Company, Clifton, New Jersey, or other similarly compactible materials. A layer of compactible material 106 comprised of the same material as layer 104 is positioned in abutment with metallic sheet 164 of structured copper strain buffer 160.

The assembly formed by semiconductor device wafer 70, structured copper strain buffers 55 and 160 and metallic layers 94 and 96 and metallizations 98 and 100 disposed therebetween, together with compactible layers 104 and 106, is positioned in the press between raised portions 88a and 90a as shown in Figure 8. A conventional press (not shown) is used to squeeze upper plate 22 and lower plate 24 together and while such pressure is applied to those plates, bolts 28 and 30 are tightened.

The thermo-compression diffusion bonds between structured copper strain buffer 55 and wafer 70, and between structured copper strain buffer 160 and wafer 70 are actually formed when the press containing the above-described assembly, shown in Figure 8, is surrounded by an inert atmosphere and heated at a temperature within the range of 300°C. to 400°C., typically 325°C., for approximately 15 minutes to 5 hours. When the press is heated in this manner, upper plate 22, lower plate 24 and metallic pressing blocks 88 and 90 expand to a greater total extent than do metallic bolts 84 and 86. Therefore, a force is exerted between raised portions 88a and 90a, resulting in the squeezing of structured copper strain buffers 55 and 160 and semiconductor device wafer 70 together and the thermo-compression diffusion bonding of buffers 55 and 160 to wafer 70. The respective thermo-compression diffusion bonds are formed between the portions of wafer 70 and buffers 55 and 160 which experience compressive stress. Guide members 92 expands with temperature to an equal or greater total extent than do metallic pressing blocks 88 and 90 such that guide 92 does not become thermo-compression diffusion bonded thereto.

Although reference is made herein to the thermo-compression diffusion bonding of strain buffers 55 and 160 to wafer 70 for simplicity of description, those skilled in the art will appreciate that the actual thermo-compression diffusion bonds are formed at the interface between the common end of copper strands 62 and metallization 98, and at the interface between the common end of copper strands 162 and metallization 100.

During thermo-compression diffusion bonding, substrateless semiconductor device wafer 70 is subjected to high pressures, specifically 1380 to 3450 bar. If this force were not purely compressive, that is, if the semiconductor device wafer 70 is subjected to bowing forces, especially in the region of beveled surface 70c, wafer 70 would likely fracture, resulting in a damaged, unusable semiconductor device. It is thus extremely important that uniform, high pressure be applied over wafer 70.

Prior bonding methods utilized a support plate attached to the semiconductor device wafer to enable the wafer to withstand some degree of bowing forces and nonuniform pressure without fracturing. No such support plate structure is necessary in the present invention, however, since essentially equal pressures are applied to essentially identical selected regions of wafer surfaces 70a and 70b, respectively, which are precisely aligned both axially and rotationally. Such pressures are applied via raised portions 88a and 90a through the intermediate layers of compactible material 104 and 106, strain buffers 55 and 160, metallizations 98 and 100, and metallic layers 94 and 96. Because wafer 70 thus experiences purely compressive pressures, it is not subjected to bowing forces and fracturing that may result therefrom.

Layers of compactible material 104 and 106 are positioned as described above to assure that during thermo-compression diffusion bonding, structured copper strain buffers 55 and 160 do not undesirably diffusion bond to raised surfaces 88a and 90a, respectively. Use of such layers of compactible material facilitates the creation of uniform, substantially void-free diffusion bonds which can otherwise occur when the bonding together of irregular surfaces is attempted. When compressed under high pressure, the layers of compactible material fill in the irregularities in the surfaces allowing raised surfaces 88a and 90a to apply a more evenly distributed pressure to strain buffers 55 and 160 and hence to each of the individual members which are to be bonded together. Use of layers of compactible material 104 and 106 is preferable but not essential to practice of the invention.

Upon completion of the bonding operation bolts 28 and 30 are loosened to permit removal of the bonded strain buffer-wafer assembly from the press.

After the bonding operation, beveled surface 70c is cleaned by such techniques as sputter etching, for example, which is preferable to conventional hot chemical etch cleaning because such an etch likely would chemically attach the structured copper strain buffers bonded to semiconductor device wafer 70. Subsequent to cleaning, beveled surface 70c is coated with a passivation material, such as polyimide siloxane, for example.

In actual practice of the invention, heat sinks (not shown) are respectively attached to metallic sheets 57 and 164 of strain buffers 55 and 160. This is accomplished by thermo-compression diffusion bonding during the course of the bonding of strain buffers 55 and 160, to wafer 70, or at a later time as is convenient. Alternatively, heat sink attachment may be accomplished by other suitable means of joining metals together, such as soldering, for example. Thermo-compression diffusion bonding, however, is preferred because it inherently results in superior thermal conductivity between metallic members which joins together, allowing more efficient removal of heat from the semiconductor device wafer.

Practice of the invention is not limited to circular geometries for the various wafers, strain buffers and other layers being bonded onto semiconductor device assemblies. Rather, other geometrics, such as squares, rectangles, polygons and the like may be used in a manner consistent with the practice of the invention.

The foregoing describes a press apparatus and methods for thermo-compression diffusion bonding structured copper strain buffers to one or each of the opposed major surfaces of a substrateless semiconductor device wafer. Such bonding is achieved without subjecting the wafer to forces, such as bowing forces, which would tend to cause wafer fracture. The method accommodates both beveled and non-beveled semiconductor device wafers.

**Description for the Contracting State: CH**

This invention relates to a method for thermo-compression diffusion bonding a structured copper strain buffer to a substrateless semiconductor device wafer having two major opposed surfaces, said strain buffer including a bundle of substantially parallel, closely packed strands of copper of substantially equal length, one common end of said strands being thermo-compression diffusion bonded to a metallic sheet.

Further the invention relates to a press for diffusion bonding adapted to carrying out the above mentioned method.

In the DE—B—1 153 461 there is described a semiconductor device that necessarily includes a substrate and where the copper strand bundle is soldered to the upper electrode of said device.

In the US—A—4 046 305 there is described a press for diffusion bonding metallic surfaces of an assembly together, comprising a first metallic plate means having a predetermined thermal coefficient of expansion, second metallic plate means having a predetermined thermal coefficient of expansion, said second plate means oriented parallel to said first plate means and spaced apart therefrom so as to accept said assembly between said first and second plate means, and metallic support means connecting said first plate means to said second plate means, said support means having a thermal coefficient of expansion selected to restrict the thermal expansion thereof to a value less than the total thermal expansion in thickness of said first and second plate means when said press is heated to an elevated temperature, whereby equal pressures may be exerted on the metallic surfaces of said assembly to squeeze said surfaces together at high pressure when said press is heated to an elevated temperature.

When attaching heat sinks to the respective opposed surfaces of a semiconductor device wafer, it is often desirable that these attachments occur as close to the semiconductor device wafer as possible in order to optimize heat removal from the wafer. Such is the case when heat sinks are attached via respective structured copper strain buffers to a semiconductor device wafer. Briefly, a structured copper strain buffer comprises a bundle of substantially parallel, closely packed strands of copper of substantially equal length, one common end thereof being thermo-compression diffusion bonded to a metallic sheet.

One type of prior high power semiconductor device includes a metallic support plate or substrate, typically comprised of tungsten or molybdenum, attached to one of the opposed surfaces of a semiconductor device wafer to provide the inherently fragile wafer with structural integrity. In those devices, heat sinks have been attached via structured copper strain buffers to one or both sides of the wafer support plate structures.

It is desirable, however, to diffusion bond respective heat sinks via structured copper strain buffers "directly" to each of the opposed surfaces of a semiconductor device wafer, thereby eliminating the rather expensive metallic support plate and simultaneously providing heat sinks attached to the strain buffers with a more intimate thermal connection to the semiconductor device wafer. More efficient heat conduction away from the wafer results. The term "directly" as used herein signifies that actually such bonds are made to the metallized layers situated on the respective major opposed surface of the wafer, and not to the wafer itself.

Brief summary of the invention

The present invention is directed to increasing the conduction of heat away from a semiconductor device wafer having respective structured copper strain buffers diffusion bonded to one or each of the two major surfaces thereof. The support plate attached to the semiconductor device wafer as needed in many conventional semiconductor device structures is not required and respective structured copper strain buffers are thermo-compression diffusion bonded "directly" to one or each of the two major surfaces of the wafer.

In accordance with one preferred embodiment of the invention, an improved press for diffusion bonding metal surfaces of an assembly together as mentioned above, is characterized by first and second raised portions included in and extending from said first and second metallic plate means, respectively, toward each other, each raised portion including a flat surface having a selected geometric pattern, the geometric patterns of said first and second raised portions being substantially identical and axially and rotationally aligned with each other, each said flat surface being substantially parallel to the other.

In accordance with another preferred embodiment of the invention a method for thermo-compression diffusion bonding a structured copper strain buffer to a substrateless semiconductor device wafer having two major opposed surfaces is provided. A substrateless semiconductor device wafer is defined to be one which has no support plate attached thereto. Each of the major opposed surfaces is smoothed. One of the major opposed surfaces is coated with a first metallic layer and a second metallic layer may be coated atop the first metallic layer. The strain buffer to be bonded to the wafer includes a bundle of substantially parallel, close-packed strands of copper of substantially equal length. One common end of these strands is thermo-compression diffusion bonded to a metallic sheet, while the common end of the copper strands opposite the metallic sheet is to be thermo-compression diffusion bonded to the metal-coated major surface of the semiconductor device wafer.

The uncoated major surface of the semiconductor device is positioned in abutment with a flat reference surface of a rigid member while the common end of the copper strands opposite the metallic sheet of the strain buffer is positioned in abutment with the metal-coated surface of the semiconductor device wafer. The strain buffer-wafer-rigid member assembly thus formed is surrounded with an inert atmosphere and is squeezed together at high pressure. The assembly is heated at a temperature within the range of 300°C. to 400°C. while the same is squeezed together. Because the rigid member essentially does not yield under pressure, a thermo-compression diffusion bond between the structured copper strain buffer and the semiconductor device wafer is produced without wafer fracture.

In accordance with another preferred embodiment of the invention, a method is provided for thermo-compression diffusion bonding first and second structured copper strain buffers to a substrateless semiconductor device wafer having first and second opposed surfaces of unequal lateral extents and a beveled outer edge surface. The beveled surface is cleaned to remove contaminants therefrom and then coated with a passivation material. The semiconductor device wafer with the above-described metallic layers and metallizations disposed thereon is sandwiched between the first and second structured copper strain buffers. Each of these strain buffers is of lateral extent equal to or less or greater than the lateral extent of the respective semiconductor device wafer surface in contact therewith such that the beveled edge surface either remains uncovered or covered by either of the structured copper strain buffers. When the lateral extent of the strain buffer is greater than the lateral extent of the wafer, the strain buffer is positioned so as to overhand the entire outer edge surface of the wafer. Each structured copper strain buffer is positioned such that the common end of the copper strands opposite the metallic sheet thereof faces the semiconductor device wafer. The so-positioned semiconductor device wafer structure and structured copper strain buffers are surrounded by an inert atmosphere. A loading force is applied to identical, axially aligned portions of the first and second strain buffers, respectively, to squeeze them together at high pressure and, at the same time, the so-positioned semiconductor device wafer and structured copper strain buffers are heated at a temperature within the range of 300°C. to 400°C. Thermocompression diffusion bonds are thus formed between the two major, opposed, metal-coated surfaces of a substrateless, beveled semiconductor device wafer and respective first and second structured copper strain buffers, without wafer fracture.

In an alternative embodiment of the invention, first and second structured copper strain buffers are thermo-compression diffusion bonded to each of the two metallized major surfaces of a semiconductor device wafer. The outer edge surface of the semiconductor device wafer is beveled preferably prior to sandwiching the semiconductor device wafer between the first and second structured copper strain buffers. The separate metallic layers and metallizations are applied to each of the opposed surfaces of the semiconductor device wafer as previously set forth, but with the metallic layers and metallizations having a lateral extent sufficiently small to avoid overlapping the beveled surface. The metallic layer and metallization on the surface of the wafer which is beveled are axially aligned with each other and with the metallic layer and metallization on the opposite surface of the wafer, which likewise are axially aligned with each other. All metallic layers and metallizations are formed with an equal lateral extent. The semiconductor device wafer is then sandwiched between the first and second strain buffers and the semiconductor device wafer and first and second structured copper strain buffers are squeezed together while being heated in an inert atmosphere, as described above. The metallic sheet of the first structured copper strain buffer is thereafter cut, preferably with a laser beam to remove the portion of the first strain buffer not bonded to the semiconductor device wafer. The beveled edge surface of the wafer is cleaned, typically by sputter etching, and is then passivated. Thermo-compression diffusion bonds are thus formed between the two major opposed surfaces of the beveled semiconductor device wafer and respective first and second structured copper strain buffers without wafer fracture.

The invention may best be understood by reference to the following description taken in conjunction with the accompanying drawings.

Figure 1 is a cross-sectional side view of a thermo-compression diffusion bonding press showing materials situated in the press to be bonded together in practicing the invention.

Figure 2 illustrates the diffusion bonding press of Figure 1 with a layer of compactible material situated between a metallic pressing block and a structured copper strain buffer to avoid the undesirable bonding of the pressing block to the strain buffer in accordance with the invention.

Fig. 3 is a cross-sectional view of a beveled semiconductor device with structured copper strain buffers having a lateral extent greater than the lateral extent of the wafer thermo-compression diffusion bonded to each of the opposed surfaces of the wafer.

Figure 4 illustrates laser cutting of a portion of a structured copper strain buffer in preparation for passivating the semiconductor device wafer diffusion bonded thereto.

Figure 5 is a top view of the bonded semiconductor device wafer-strain buffer structure shown in Figure 4 after removal of the portions of the strain buffer cut away by the laser.

Figure 6 is a cross-sectional side view of the wafer-strain buffer structure shown in Figure 5, after passivation.

Figure 7 is a cross-sectional view of a beveled semiconductor device wafer with structured copper strain buffers having a lateral extent greater than the lateral extent of the wafer thermo-compression diffusion bonded to each of the metal-coated, opposed surfaces of the wafer.

Figure 8 is a cross-sectional side view of an improved thermo-compression diffusion bonding press showing materials to be bonded together situated therein.

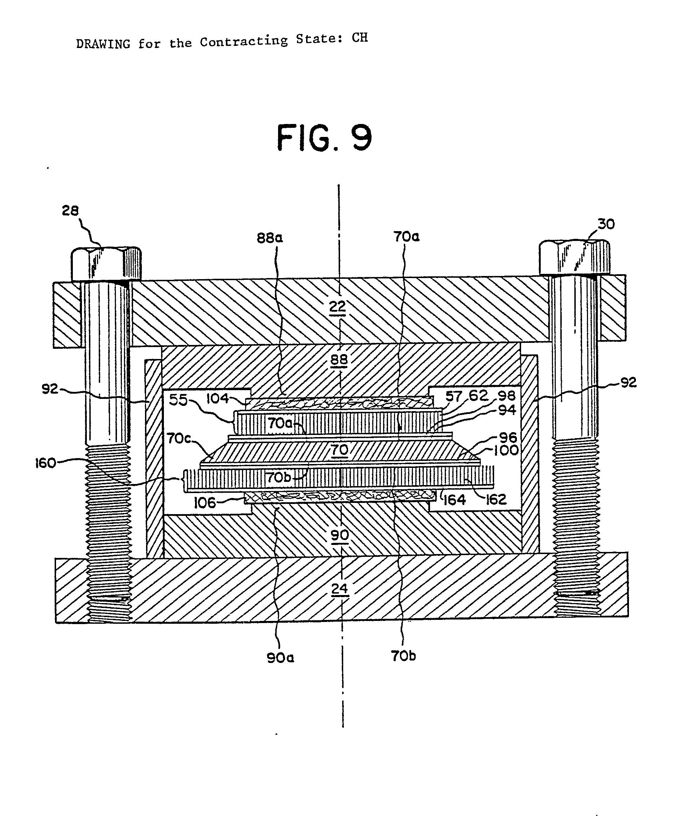

Figure 9 is a cross-sectional side view of the thermo-compression diffusion bonding press of Figure 8 showing materials of alternative configuration situated therein to be bonded together.

Figure 1 shows a diffusion bonding press 10 which may be used in thermo-compression diffusion bonding a structured copper strain buffer 12 directly to a substrateless semiconductor device wafer 16. Press 10 is comprised of an upper metallic plate 22 oriented parallel to a lower metallic plate 24 with a space provided therebetween. A metallic pressing block 26 is positioned at the centre of the side of upper plate 22 facing lower plate 24. Metallic bolts 28 and 30 pass through respective holes in upper plate 22 and lower plate 24 and are threaded into lower plate 24 to connect the two plates together as illustrated in Figure 1.

Metallic bolts 28 and 30 are comprised of a steel other than stainless steel, while upper plate 22, lower plate 24 and metallic pressing block 26 are comprised of stainless steel. Metallic pressing block 26 may alternatively be comprised of Dural, an aluminum alloy, or other metals having a coefficient of thermal expansion greater than that of steel.

To achieve a thermo-compression diffusion bond between structured copper strain buffer 12 and semiconductor device wafer 16, a disk or rigid material 20 having a flat reference surface 20a is situated within press 10 on lower plate 24. Member 20 is comprised of a rigid material such as quartz, for example, which will withstand high pressures of 1380 to 3450 bar without measurably yielding.

Each of the opposed major surfaces of semiconductor device wafer 16 is smoothened to remove surface damage therefrom. Such surface damage would otherwise cause nonuniform distribution of pressures within wafer 16 and, thus, wafer breakage when the wafer is subjected to the high pressure employed in the thermo-compression diffusion bonding process of the invention. This step of smoothing may be accomplished, for example, by polishing or etching each of the opposed major surfaces.

One of the two major opposed surfaces of wafer 16 is provided with a first metallic layer 21, comprised of one of such metals as titanium, chromium and nickel, coated thereon. A second metallic layer 23 comprised of one of such metals as copper, silver and gold is applied over the metallic layer 21. Metallic layers 21 and 23 may be applied to wafer 16 by sputtering or evaporation, for example.

Structures to be diffusion bonded together are situated upon surface 20a of member 20. Specifically, wafer 16 is situated on surface 20a with the uncoated surface of wafer 16 positioned facing surface 20a.

Structured copper strain buffer 12 is positioned in abutment with the exposed surface of metallic layer 23 on wafer 16. Strain buffer 12 comprises a bundle of substantially parallel, close-packed strands of copper 40 of substantially equal length, one common end thereof being thermo-compression diffusion bonded onto a metallic sheet 14, typically comprised of copper. The remaining common end of strands 40 is situated in abutment with metallic layer 23 on wafer 16. A conventional press (not shown) is used to squeeze upper plate 22 and lower plate 24 together and while such pressure is applied to these plates, bolts 28 and 30 are tightened.

The thermo-compression diffusion bond between structured copper strain buffer 12 and semiconductor device wafer 16 is actually formed when press 10 containing rigid member 20, semiconductor device wafer 16 with metallic layers 21 and 23 disposed thereon and structured copper strain buffer 12, positioned as described above and as shown in Figure 1, are placed in an inert atmosphere and heated at a temperature within the range of 300°C. to 400°C., typically 325°C., for approximately 15 minutes to 5 hours. When press 10 is heated in this manner, upper plate 22, lower plate 24, and metallic pressing block 26 expand to a greater total extent than do metallic bolts 28 and 30. Therefore, a force is exerted between pressing block 26 and lower plate 24 resulting in the squeezing of structured copper strain buffer 12 and semiconductor device wafer 16 together and the thermo-compression diffusion bonding of each to the other. Although frequent reference is made herein to the thermo-compression diffusion bonding of structured copper strain buffer 12 to semiconductor device wafer 16 for simplicity of description, those skilled in the art will appreciate that the thermo-compression diffusion bond is actually formed between the common end of copper strands 40 opposite metallic sheet 14 and metallic layer 23 on wafer 16.

During thermo-compression diffusion bonding, semiconductor device wafer 16 is subjected to high pressure, specifically, 1380 to 3450 bar. If this force is not purely compressive, that is, if semiconductor device wafer 16 is subjected to bowing or tensile forces, wafer 16 will likely fracture, resulting in a damaged semiconductor device. It is thus extremely important that uniform high pressure be applied over the entire wafer 16. The surfaces of the members to be bonded together must be flat and parallel to each other and to the opposed, facing surfaces of lower plate 24 and metallic pressing block 26. Situating rigid member 20 on lower plate 24 provides an essentially non-yielding, flat reference surface for semiconductor device wafer 16 placed thereon. Employing rigid member 20 in this manner assures that semiconductor device wafer 16 is subjected to substantially pure compressive forces during thermo-compression diffusion bonding, with negligible tensile forces being exerted on the wafer, enabling the diffusion bond to be achieved without fracture of the substrateless wafer. The resulting bonded semiconductor device wafer-strain buffer-heat sink assembly includes no substrate or support plate. Heat is conducted more efficiently away from the wafer to the heat sink than if the assembly were to include such substrate.

Figure 2 is identical to Figure 1 with like numerals signifying like components, except for the placement of a layer (32) of nonreactive compactible material between the pressing block 26 and strain buffer 12. In accordance with the preferred embodiment of the invention, layer 32 is so positioned prior to application of the loading force discussed in the method set forth above. Such layer of compactible material tends to compress under application of the loading force, filling in any irregularities in the facing surface of metallic sheet 14 and resulting in a more uniform distribution of the loading force on strain buffer 12. The thermo-compression diffusion bond between strain buffer 12 and wafer 16 is thus made substantially void free. Layer 32 additionally prevents strain buffer 12 from undesirably adhering to metallic pressing block 26 during thermo-compression diffusion bonding. Layer 32 may be comprised of glass wood, or Glass Fiber Filter paper available from Fisher Scientific Company, Clifton, New Jersey, or other similarly compactible materials.

Figure 3 shows a diffusion bonding press 10 suitable for thermo-compression diffusion bonding a first structured copper strain buffer 12 and a second structured copper strain buffer 74, respectively, to the opposed major surfaces 16a and 16b of substrateless semiconductor device wafer 16. The outer edge surface 16c of semiconductor device wafer 16 is preferably beveled, as shown in Figure 3, although the invention encompasses wafers both with and without a beveled outer edge surface.

To achieve the respective thermo-compression diffusion bonds between strain buffers 12 and 74 and wafer 16, surfaces 16a and 16b are smoothened to remove surface damage therefrom. Such surface damage would otherwise cause nonuniform distribution of pressures within wafer 16 and thus wafer breakage when wafer 16 is subjected to the high pressures employed in the thermo-compression diffusion bonding process of the invention. This step of smoothing may be accomplished, for example, by polishing or etching surfaces 16a and 16b.

Metallic layers 31 and 37 are applied to wafer surfaces 16a and 16b, respectively. Each of metallic layers 31 and 37 is comprised of one of such metals as titanium, chromium and nickel. Metallizations 34 and 36 are respectively applied over metallic layers 31 and 37. Each of metallizations 34 and 36 are respectively comprised of one of such metals as copper, gold and silver. These metallic layers and metallizations may be applied to wafer 16 by sputtering or evaporation, for example.

The wafer-metallic layer-metallization structure thus formed is sandwiched between structured copper strain buffers 12 and 74. Structured copper strain buffer 12 is comprised of a bundle of substantially parallel, closely packed strands of copper 40 of substantially equal length with one common end thereof thermo-compression diffusion bonded to a metallic sheet 42, typically comprised of copper. The opposite common end of copper strands 40 is positioned in abutment with metallization 34. Structured copper strain buffer 74 is essentially identical to structured copper strain buffer 12 and is comprised of copper strands 50 and metallic sheet 52. The common end of copper strands 50 opposite metallic sheet 52 is positioned in abutment with metallization 36.

A layer 54 of nonreactive compactible material is situated in abutment with metallic sheet 42 of structured copper strain buffer 12. Layer 54 may be comprised of glass wood or Glass Fiber Filter paper available from Fisher Scientific Company, Clifton, New Jersey, or other similarly compactible material. A layer of compactible material 56 preferably comprised of the same material as layer 54 is positioned in abutment with metallic sheet 52 of structured copper strain buffer 74.

The combined structure formed by semiconductor device wafer 16, structured copper strain buffers 12 and 74, and metallic layers 31 and 37 and metallizations 34 and 36 disposed therebetween and compactible layers 54 and 56 is positioned in press 10 between pressing block 26 and lower plate 24. A conventional press (not shown) is used to squeeze upper plate 22 and lower plate 24 together and while such pressure is applied to these plates, bolts 28 and 30 are tightened.

The thermo-compression diffusion bonds between structured copper strain buffer 12 and wafer 16, and between structured copper strain buffer 74 and wafer 16 are actually formed when press 10 containing the above-described combined structure, illustrated in Figure 1, is surrounded by an inert atmosphere and heated at a temperature within the range of 300°C. to 400°C., typically 325°C., for approximately 15 minutes to 5 hours. When press 10 is heated in this manner, upper plate 22, lower plate 24 and metallic pressing block 36 expand to a greater total extent than do metallic bolts 28 and 30. Therefore, a force is exerted between pressing block 26 and lower plate 24, resulting in the squeezing of structured copper strain buffers 12 and 74 and semiconductor device wafer 16 together and the thermo-compression diffusion bonding of buffers 12 and 74 to wafer 16. The now-formed strain buffer-wafer assembly 60 is removed from press 10 by loosening bolts 28 and 30. Although reference is made herein to the thermo-compression diffusion bonding of strain buffer 12 to wafer 16 and strain buffer 74 to wafer 16 for simplicity of description, those skilled in the art will appreciate that the actual thermo-compression diffusion bonds are formed at the interface between the common end of copper strands 40 and metallization 34, and at the interface between the common end of copper strands 50 and metallization 36.

During thermo-compression diffusion bonding, substrateless semiconductor device wafer 16 is subjected to high pressures, specifically 1380 to 3450 bar. If this force is not purely compressive, that is, if semiconductor device wafer 16 is subjected to bowing or tensile forces, wafer 16 will likely fracture, resulting in a damaged semiconductor device. It is thus extremely important that uniform high pressure be applied over the entire wafer 16.

Prior methods of thermo-compression diffusion bonding used a support plate attached to the semiconductor device wafer to enable the wafer to withstand some degree of bowing forces and nonuniform pressure without fracture. When attempting thermo-compression diffusion bonding of members to a "substrateless" semiconductor device wafer, it is important that the surfaces of the members to be bonded together be flat and parallel to each other and to the opposed facing surface of lower plate 24 and metallic pressing block 26. To solve the problem of bowing forces being generated near the edge surface of wafer 16 during thermo-compression diffusion bonding as would occur if strain buffers 12 and 74 did not extend over the entire lateral extent of wafer 16, the lateral extent of structured copper strain buffers 12 and 74 is made greater than the lateral extent of wafer 16 such that buffers 12 and 74 overhang wafer 16 around the entirety of its edge surface.

Layers of compactible material 54 and 56 are positioned as described above to assure that during thermo-compression diffusion bonding, structured copper strain buffer 12 does not adhere undesirably to pressing block 26 and to assure that structured copper strain buffer 74 similarly does not bond to lower plate 24. Use of such layers of compactible material helps assure the creation of uniform, substantially void-free diffusion bonds. Voids in diffusion bonds may result when a thermo-compression diffusion bond between a compliant metallic member (such as a structured copper strain buffer) and another member having some degree of surface irregularity is attempted. When compressed, the layers of compactible material fill in the irregularities in the surface of the respective structured copper strain buffers allowing the diffusion bonding press 10 to apply a more evenly distributed pressure to the members which are to be bonded together. Use of layers of compactible material 54 and 56 is preferable but not essential to practice of the method of the invention.

If semiconductor device wafer 16 is of the nonbeveled variety, no further processing in accordance with the invention is required. However, if wafer 16 includes a beveled outer edge surface 16c, as illustrated, it is desirable that surface 16c be cleaned and passivated to protect it from external contamination. As shown in Figure 4, beveled edge surface 16c lies recessed under structured copper strain buffer 12 and is thus inaccessible for cleaning and passivation purposes. It would be undesirable to passivate beveled surface 16c prior to thermo-compression diffusion bonding since the additional thickness of the passivant, which would likely become affixed to the outer edge of wafer surfaces 16a and 16b would cause uneven pressure on the wafer during such diffusion bonding and likely result in fracturing the wafer. Therefore, passivation of beveled surface 16c is achieved in the following manner. Prior to sandwiching wafer 16 between structured copper strain buffers 12 and 74, metallic layers 31 and 37, applied to major surfaces 16a and 16b, respectively, of wafer 16, are formed with a lateral extent sufficiently small so as to avoid overlapping beveled surface 16c. That is, the lateral extent of layers 31 and 37 may be equal to or less than the lateral extent of surface 16a. Metallizations 34 and 36 are thereafter applied over metallic layers 31 and 37, respectively, with lateral extents equal to those of metallic layers 31 and 37, all of the above-mentioned lateral extents being equal and axially aligned with each other, as shown in Figure 4.

When the thermo-compression diffusion bonding process is carried out upon the metallized wafer structure 16, the common end of copper strands 40 opposite metallic sheet 42 of strain buffer 12 becomes thermo-compression diffusion bonded only to the metallized portions of surface 16a. Similarly, the common end of copper strands 50 opposite metallic sheet 52 of strain buffer 74 diffusion bonds only to metallized portions of surface 16b.

A laser device 62 such as a pulsed laser, typically having a peak pulsed power of 16 KW although not limited thereto, generates a beam of coherent light which is directed along a selected path on metallic sheet 42 of strain buffer wafer assembly 60, fabricated as previously described, so as to form an incision 64 in sheet 42 and thus allow the removal of most of the portion of strain buffer 12 not bonded to wafer metallization 34. The portion of structured copper strain buffer 12 outside incision 64 is removed to form wafer-buffer structure 170 shown in Figure 5. The remaining portion of strain buffer 12 is designated strain buffer 12'. Beveled edge surface 16c is thus made accessible for cleaning and passivation.

Chemically etching the surface of a beveled semiconductor device wafer is a method for wafer cleaning well known in the art. However, such an etching step, if applied to wafer-buffer structure 170 would result in the undesirable chemical attack of the structured copper strain buffers 12 and 74 by the etchant. Rather, beveled surface 16c is subjected to sputter etching to remove contaminants therefrom prior to passivation.

Subsequently, beveled surface 16c is coated with a passivation layer 82 comprised of one of the many passivation materials known in the art, polyimide siloxane, for example, as illustrated in Figure 6.

To complete the device thus formed, heat sinks (not shown) are respectively attached to metallic layers 42 and 52 of strain buffers 12' and 74. This is preferably accomplished by thermo-compression diffusion bonding during the course of attachment of strain buffers 12 and 74 to wafer 16 or at a later time. Although heat sink attachment may be accomplished by other means of joining metals together, soldering, for example, thermo-compression diffusion bonding is preferred because it inherently achieves superior thermal conductivity between the joined metallic members.

Thermo-compression diffusion bonding of the above method results in the intermediate structure shown in Figure 7 wherein a semiconductor device wafer 16 includes opposed major surfaces 16a and 16b and beveled edge surface 16c. First and second metallic layers 31 and 37 are coated respectively on surfaces 10a and 10b. Metallizations 34 and 36 are coated, respectively, on metallic layers 31 and 37. Structured copper strain buffers 12 and 74 are thermo-compression diffusion bonded respectively to metallizations 34 and 36. Structured copper strain buffer 12 includes a bundle of substantially parallel closely packed strands of copper 40, one common end thereof thermo-compression diffusion bonded into a metallic sheet 42. Structured copper strain buffer 74 is substantially similar to strain buffer 12 and includes copper strands 50 and metallic sheet 52. As pointed out above, structured copper strain buffers 12 and 74 are formed in such a manner as to have a lateral extent greater than that of silicon wafer 16, so as to prevent the silicon wafer 16 from being subjected to bowing forces which cause wafer fracture. Bowing forces are thus substantially eliminated; however, this bonding method essentially prohibits cleaning and passivating beveled surface 16c prior to bonding because of the high probability that passivant applied to surface 16c would flow onto portions of surfaces 16a and 16b, causing wafer 16 to experience bowing forces and nonuniform pressure when thermo-compression diffusion bonding is attempted. To allow passivation of the beveled edge 16c therefore, a laser beam is used to cut away the portion of structured copper strain buffer 12 overhanging beveled surface 16c. Beveled surface 16c is thereby exposed for cleaning, preferably via sputter etching, and passivating. Conventional economical chemical etching is not a preferable method for cleaning beveled surface 10c because the etchant would chemically attack the structured copper strain buffers 12 and 74.

This embodiment constitutes an alternative solution to the problem of preventing bowing forces when thermo-compression diffusion bonding structured copper strain buffers to a substrateless semiconductor device wafer. One embodiment of the invention desirably allows cleaning of the beveled surface via conventional chemical etching and passivation prior to diffusion bonding.

As illustrated in Figure 8, a press apparatus 10 is provided to bond first and second structured copper strain buffers 55 and 65, respectively, to the opposed major surfaces 70a and 70b of substrateless semiconductor device wafer 70. The outer edge 70c of semiconductor device wafer 70 is beveled as shown in Figure 8.

Bonding press 10 includes an upper metallic plate 22 oriented parallel to a lower metallic plate 24 with a space provided therebetween. Metallic bolts 28 and 30 pass through respective holes in upper plate 22 and lower plate 24 and are threaded into lower plate 24 to connect the two plates together as illustrated in Figure 8. A metallic pressing block (or expansion block) 88 is positioned at the center of the lower surface of upper plate 22 and attached thereto. A similar metallic pressing block (or expansion block) 90 is positioned at the center of the upper surface of lower plate 24 and attached thereto. Pressing blocks 88 and 90 each include raised portions 88a and 90a respectively extending therefrom and facing each other. Raised portion 88a has a flat surface of a selected geometric pattern, circular, square, rectangular or various other polygons, for example, which is axially and rotationally aligned with a like flat surface of identical geometric pattern on raised portion 90a. The flat surfaces of raised portions 88a and 90a are parallel to each other. Raised portions 88a and 90a are held in alignment by a guide member 92 positioned in abutment with pressing blocks 88 and 90. Guide member 92 is conveniently of cylindrical shape having an inner diameter sufficiently large to accommodate the maximum lateral extent of pressing blocks 88 and 90 therein.

Metallic pressing blocks 88 and 90 are comprised of a metal having a thermal coefficient of expansion greater than that of metallic bolts 28 and 30. For example, pressing blocks 88 and 90 may be comprised of such metals as stainless steel, Dural and other aluminum alloys. Guide member 92 is comprised of a material having a thermal coefficient of expansion equal to or greater than that of pressing blocks 88 and 90.

To achieve the respective thermo-compression diffusion bonds between strain buffers 55 and 65 and wafer 70, surfaces 70a and 70b are smoothened to remove surface damage therefrom. Such surface damage would otherwise cause nonuniform distribution of pressures within wafer 70 and thus wafer fracture when wafer 70 is subjected to the high pressures employed in the thermo-compression diffusion bonding process of the invention. Metallic layers 94 and 96 are then applied to surfaces 70a and 70b, respectively. Each of the metallic layers 94 and 96 are comprised of one of such metals as titanium, chromium and nickel. Metallizations 98 and 100 are respectively applied over metallic layers 94 and 96 and are comprised of such metals as copper, silver and gold. Beveled surface 70c is then cleaned to remove contaminants therefrom. A chemical etch may be used to perform this cleaning since at this juncture the structured copper strain buffers are not yet bonded to wafer 70 and thus there is no opportunity for the etch to chemically attack the structured copper strain buffers. Alternately, sputter etching may be used to clean beveled surface 70c. After being cleaned, beveled surface 70c is coated with a passivation material 102 such as polyimide siloxane, for example. Passivation material 102 may partially extend on to major surfaces 70a and 70b without causing the undesirable generation of bowing forces in wafer 16 during subsequent thermo-compression diffusion bonding. ,

The wafer-metallic-layer-metallization-passivation assembly thus formed is sandwiched between structured copper strain buffers 55 and 65. Structured copper strain buffer 55 is comprised of a bundle of substantially parallel, closely packed strands of copper 62 of substantially equal length with one common end thereof being thermo-compression diffusion bonded to a metallic sheet 57. The opposite common end of copper strands 62 is positioned in abutment with metallization 98. Structured copper strain buffer 65 is essentially identical to structured copper buffer 55 and is comprised of copper strands 58 and metallic sheet 59. The common end of copper strands 58 opposite metallic sheet 59 is positioned in abutment with metallization 100. Strain buffers 55 and 65 each have a lateral extent equal to or less than the lateral extent of the respective wafer 70 surface in contact therewith such that beveled surface 70c remains uncovered by either of the strain buffers. Additionally, the lateral extent of strain buffers 55 and 65 is sufficiently small such that buffers 55 and 65 do not overlap any passivation material 102 which may be present on wafer surfaces 70a and 70b, respectively. If such overlap were to occur, undesirable bowing forces would likely result.

A layer 104 of nonreactive, compactible material is situated in abutment with metallic sheet 57 of structured copper strain buffer 55. Layer 104 may be comprised of glass wool or Glass Fiber Filter paper available from Fisher Scientific Company, Clifton, New Jersey, or other similarly compactible materials. A layer of compactible material 106 comprised of the same material as layer 104 is positioned in abutment with metallic sheet 59 of structured copper strain buffer 65.

The assembly formed by semiconductor device wafer 70, structured copper strain buffers 55 and 65, and metallic layers 94 and 96 and metallizations 98 and 100 disposed therebetween, together with compactible layers 104 and 106, is positioned in the press between raised portions 88a and 90a as shown in Figure 8. A conventional press (not shown) is used to squeeze upper plate 22 and lower plate 24 together and while such pressure is applied to those plates, bolts 28 and 30 are tightened.

The thermo-compression diffusion bonds between structured copper strain buffer 55 and wafer 70, and between structured copper strain buffer 65 and wafer 70 are actually formed when press 10 containing the above-described assembly, shown in Figure 8, is surrounded by an inert atmosphere and heated at a temperature within the range of 300°C. to 400°C., typically 325°C., for approximately 15 minutes to 5 hours. When press 10 is heated in this manner, upper plate 22, lower plate 24 and metallic pressing blocks 88 and 90 expand to a greater total extent than do metallic bolts 84 and 86. Therefore,° a force is exerted between raised portions 88a and 90a, resulting in the squeezing of structured copper strain buffers 55 and 65 and semiconductor device wafer 70 together and the thermo-compression diffusion bonding of buffers 55 and 65 to wafer 70. The respective thermo-compression diffusion bonds are formed between the portions of wafer 70 and buffers 55 and 65, which experience compressive stress. Guide members 92 expands with temperatures to an equal or greater total extent than do metallic pressing blocks 88 and 90 such that guide 92 does not become thermo-compression diffusion bonded thereto.

Although reference is made herein to the thermo-compression diffusion bonding of strain buffers 55 and 65 to wafer 70 for simplicity of description, those skilled in the art will appreciated that the actual thermo-compression diffusion bonds are formed at the interface between the common end of copper strands 62 and metallizations 98, and at the interface between the common end of copper strands 58 and metallization 100.

During thermo-compression diffusion bonding, substrateless semiconductor device wafer 70 is subjected to high pressures, specifically 1380 to 3450 bar. If this force were not purely compressive, that is, if the semiconductor device wafer 70 is subjected to bowing forces, especially in the region of beveled surface 70c, wafer 70 would likely fracture, resulting in a damaged, unusable semiconductor device. It is thus extremely important that uniform, high pressure be applied over wafer 70.

Prior bonding methods utilized a support plate attached to the semiconductor device wafer to enable the wafer to withstand some degree of bowing forces and nonuniform pressure without fracturing. No such support plate structure is necessary in the present invention, however, since essentially equal pressures are applied to essentially identical selected regions of wafer surfaces 70a and 70b, respectively, which are precisely aligned both axially and rotationally. Such pressures are applied via raised portions 88a and 90a through the intermediate layers of compactible material 104 and 106, strain buffers 55 and 65, metallizations 98 and 100, and metallic layers 94 and 96. Because wafer 70 thus experiences purely compressive pressures, it is not subjected to bowing forces and fracturing that may result therefrom.

Layers of compactible material 104 and 106 are positioned as described above to assure that during thermo-compression diffusion bonding, structured copper strain buffers 55 and 65 do not undesirably diffusion bond to raised surfaces 88a and 90a, respectively. Use of such layers of compactible material facilitates the creation of uniform substantially void-free diffusion bonds which can otherwise occur when the bonding together of irregular surfaces is attempted. When compressed under high pressure, the layers of compactible material fill in the irregularities in the surfaces allowing raised surfaces 88a and 90a to apply a more evenly distributed pressure to strain buffers 55 and 65 and hence to each of the individual members which are to be bonded together. Use of layers of compactible material 104 and 106 is preferable but not essential to practice of the invention.

Upon completion of the bonding operation, bolts 28 and 30 are loosened to permit removal of the bonded strain buffer-wafer assembly from press 10.

In accordance with another embodiment of the invention, as illustrated in Figure 9, an "oversized" structured copper strain buffer 160, that is, a strain buffer having a lateral extent equal to or greater than the larger major surface of substrateless wafer 70 having a beveled edge surface 70c, is thermo-compression diffusion bonded to surface 70b of wafer 70, and a structured copper strain buffer 55 having a lateral extent sufficiently small so as to overlap beveled surface 70c of wafer 70 is thermo-compression diffusion bonded to surface 70a of substrateless wafer 70. The diffusion bonds are formed without subjecting semiconductor device wafer 70 to bowing forces which would likely cause it to fracture. Figure 9 shows press 10 with materials situated therein for bonding. Press 10 of Figure 9 is similar to that of Figure 8, with like numerals indicating like elements. The method for creating such thermo-compression diffusion bonds between wafer 70 and each of strain buffer 55 and "oversized" strain buffer 160 is identical to that described in conjunction with Figure 8, except for the following differences.

"Oversized" strain buffer 160 is employed instead of strain buffer 65 shown in Figure 8. Additionally, beveled surface 70c is cleaned and passivated only after the desired thermo-compression diffusion bonds have been formed, preventing passivation material intended for beveled surface 70c from coating portions of major surfaces 70a and 70b near beveled surface 70c before bonding and thereby creating an irregularity in these major surfaces which might result in generation of some unacceptable bowing force during thermo-compression diffusion bonding and consequential wafer fracture.

After the bonding operation, beveled surface 70c is cleaned by such techniques as sputter etching, for example, which is preferable to conventional hot chemical etch cleaning because such an etch likely would chemically attack the structured copper strain buffers bonded to semiconductor device wafer 70. Subsequent to cleaning, beveled surface 70c is coated with a passivation material 202 such as polyimide siloxane, for example.

In actual practice of the invention, heat sinks (not shown) are respectively attached to metallic sheets 57 and 59 of strain buffers 55 and 65. This is accomplished by thermo-compression diffusion bonding during the course of the bonding of strain buffers 55 and 65 to wafer 70, or at a later time as is convenient. Alternatively, heat sink attachment may be accomplished by other suitable means of joining metals together, such as soldering, for example. Thermo-compression diffusion bonding, however, is preferred because it inherently results in superior thermal conductivity between the metallic members which it joins together, allowing more efficient removal of heat from the semiconductor device wafer.

Practice of the invention is not limited to circular geometrics for the various wafers, strain buffers and other layers being bonded into semiconductor device assemblies. Rather, other geometrics, such as squares, rectangles, polygons and the like may be used in a manner consistent with the practice of the invention.

The foregoing describes a press apparatus and methods for thermo-compression diffusion bonding structured copper strain buffers to one or each of the opposed major surfaces of a substrateless semiconductor device wafer. Such bonding is achieved without subjecting the wafer to forces, such as bowing forces, which would tend to cause wafer fracture. The method accommodates both beveled and non-beveled semiconductor device wafers.

**Claims for the Contracting States: DE FR GB SE**

1. A method for thermo-compression diffusion bonding a structured copper strain buffer (12) to a substrateless semiconductor device wafer (16) having two major opposed surfaces, said strain buffer including a bundle of substantially parallel, closely packed strands (40) of copper of substantially equal length, one common end of said strands being thermo-compression diffusion bonded to a metallic sheet (14), comprising the steps of:

applying a first metallic layer (21) to one of said major surfaces;

applying a second metallic layer (23) to said first metallic layer;

positioning the common end of the strands of said strain buffer, having a lateral extent at least equal to that of said wafer surfaces, opposite said metallic sheet in abutment with said second metallic layer;

surrounding the semiconductor device wafer and strain buffer with an inert atmosphere;

applying a loading force to squeeze together at high pressure, said semiconductor device wafer and said strain buffer; and

heating said semiconductor device wafer and said strain buffer at a temperature within the range of 300°C. to 400°C. while said loading force is applied.

2. A method according to claim 1 characterized by the steps of:

applying first (31) and second metallic layers (37), respectively, over the first (16a) and second major opposed surfaces (16b) of said semiconductor device wafer (16);

applying first (34) and second metallizations (36), respectively, over said first and second metallic layers;

sandwiching said semiconductor device wafer between said first (12) and second structured copper strain buffers (74), the surface of each structured copper strain buffer opposite the respective metallic sheet (42, 52) thereof being positioned facing said wafer, said structured copper strain buffers each having a lateral extent greater than the lateral extent of said semiconductor device wafer and being so positioned as to overhang the entire outer edge surface (16c) of said semi-conductor device wafer.

3. A method according to claims 1 or 2 characterized by positioning in abutment with a flat reference surface (20a) of a rigid member (20) the surface of the semiconductor device wafer (16) opposite the wafer surface having the first (21) and second metallic layers (23) disposed thereon.

4. The method of claims 1 or 3 characterized in that the rigid member (20) is comprised of quartz.

5. A method according to claim 1 characterized in that the first (16a) and second major opposed surfaces (16b) of unequal lateral extents and a beveled outer edge surface (16c); coating said beveled surfaces with a passivation material (82); sandwiching said semiconductor device wafer between and in axial alignment with said first (12') and second structured copper strain buffers (74), each of said structural copper strain buffers having a lateral extent at least equal to the lateral extent of the respective major surface of said semiconductor device wafer in contact therewith such that said beveled edge remains uncovered by either of said structured copper strain buffers, the common end of the copper strands (40', 50) of each of said first and second structured copper strain buffers opposite the respective metallic sheet (42', 52') thereof being positioned facing said semiconductor device wafers (16); applying a loading force to selected portions of said first and second structured copper strain buffers to squeeze said first and second structured copper strain buffers and said semiconductor device wafer together at high pressure, the selected portion of said first structured copper strain buffer being substantially of identical geometrical size and shape as, and substantially rotationally and axially aligned with, the selected portion of said second structured copper strain buffer.

6. The method of claim 5 characterized by the step of situating first (54) and second layers (56) of non-reactive compactible material in contact with the metallic sheets (42, 52) of said first (12) and second structured copper strain buffers (74), respectively, prior to surrounding said semiconductor device wafer (16) and structured copper strain buffers with an inert atmosphere.

7. A method according to claim 4 characterized in that the first major surface (16a) being smaller than said second major surface (16b), said first structured copper strain buffer (12') being situated on said first surface and having a lateral extent no greater than the lateral extent of said first major surface, said second structured copper strain buffer (74) having a lateral extent at least equal to the lateral extent of said second surface.

8. The method of claims 1 or 3 or 4 or 5 characterized in that the first metallic layer (21) is comprised of one of the group consisting of titanium, chromium and nickel and said second metallic layer (23) is comprised of one of the group consisting of copper, silver and gold.

9. The method of claims 2 or 5 characterized in that the first (31) and second metallic layers (37) are comprised of one of the group consisting of titanium, chromium and nickel, and said first (34) and second metallizations (36) are comprised of one of the group consisting of copper, silver and gold.

10. The method of claim 4 characterized in that the rigid member (20), said semiconductor device wafer (16) and said strain buffer (12) are heated at approximately 325°C for a time within the range of approximately 15 minutes to 3 hours while said rigid member, said semiconductor device wafer and said strain buffer are being squeezed together.

11. The method of claims 1 or 3 or 4 or 5 or 8 characterized by the step of positioning a layer (32) of nonreactive compactible material in abutment with the metallic sheet (14) of said structured copper strain buffer (12) prior to application of said loading force.

12. The method of claim 11 characterized in that the layer (32) of compactible material, said rigid member (20), said semiconductor device wafer (16) and said strain buffer (12) are heated at approximately 325°C for a time within the range of approximately 15 minutes to 3 hours while said layer of compactible material, said rigid member, said semiconductor device wafer and said strain buffer are being squeezed together.

13. The method of claims 1 or 2 or 9 characterized by the step of positioning first (54) and second layers (56) of nonreactive compactible material in abutment, respectively, with the metallic sheets (42, 52) of said first (12) and second structured copper strain buffers (74), prior to application of said loading force.

14. The method of claim 2 characterized by the step of beveling the outer edge of said semiconductor device wafer to form a beveled edge surface (16c) prior to sandwiching said semiconductor device wafer between said first (12) and second structured copper strain buffers (74), said first structured copper strain buffer being positioned facing said beveled surface.

15. The method of claim 14 characterized by the step of applying said first (31) and second metallic layers (37) comprises depositing first and second metallic layers having a lateral extent less than the lateral extent of said wafer (16) and sufficiently small so as to avoid overlapping said beveled surface (16c), said first and second metallic layers being axially aligned with each other.

16. The method of claim 15 characterized by the step of applying said first (34) and second metallizations (36) comprises depositing said first and second metallizations in such manner that said metallizations are axially aligned with said metallic layers (31, 37) and have a lateral extent equal to the lateral extent of said metallic layers.

17. The method of claim 14 characterized by the step of cutting (64) with a laser beam the metallic sheet (42) of said first structured copper strain buffer (12) in a manner allowing removal of most of the portion of said first structured copper strain buffer not bonded to said semiconductor device wafer (16) after heating said wafer.

18. The method of claim 17 characterized by the step of sputter etching said beveled edge surface (16c) of said semiconductor device wafer after cutting said metallic sheet.

19. The method of claim 18 characterized by the step of passivating said beveled edge after sputter etching said beveled edge.

20. The method of any one of the preceding claims characterized in that the high pressure is within the range of approximately 1380 to 3450 bar.

21. The method of any one of the preceding claims characterized by the step of smoothing said first and second major opposed surfaces prior to applying said first (21) and second metallic layers (23) thereon, respectively.

22. The method of any one of the preceding claims characterized by the step of smoothing is accomplished by polishing said first and second major opposed surfaces.

23. The method of any one of the preceding claims characterized by the step of smoothing is accomplished by etching said first and second major opposed surfaces.

24. A press (10) for diffusion bonding metallic surfaces of an assembly together comprising a first metallic plate means (22) having a predetermined thermal coefficient of expansion; second metallic plate means (24) having a predetermined thermal coefficient of expansion, said second plate means oriented parallel to said first plate means and spaced apart therefrom so as to accept said assembly between said first and second plate means; and metallic support means (28, 30) connecting said first plate means to said second plate means, said support means having a thermal coefficient of expansion selected to restrict the thermal expansion thereof to a value less than the total thermal expansion in thickness of said first and second plate means when said press is heated to an elevated temperature; whereby equal pressures may be exerted on the metallic surfaces of said assembly to squeeze said surfaces together at high pressure when said press is heated to an elevated temperature, first (88) and second expansion blocks (90) facing each other and attached, respectively, to said first and second plates, said first and second expansion blocks, respectively, including first (88a) and second raised portions (90a) extending towards each other, each raised portion including a flat surface having a selected geometric pattern, the geometric patterns of said first and second raised portions being substantially identical and axially and rotationally aligned with each other, each said flat surface being substantially parallel to the other.

25. The press of claim 24, wherein said first (88) and second expansion blocks (90) are fabricated of material having thermal coefficients of expansion equal to the thermal coefficient of expansion of said first (22) and second plate means (24).

26. The press of claims 24 or 25 characterized in that the first (88) and second expansion blocks (90) are fabricated of material having thermal coefficients of expansion greater than the thermal coefficient of expansion of said first (22) and second plate means (24).

27. The press of claims 24 or 25 or 26 characterized by guide means (92) extending from said first expansion block (88) to said second expansion block (90) for axially aligning said first (88a) and second raised portions (90a).

28. The press of claim 27 characterized in that the guide means comprises a metallic cylinder (92) surrounding, and in abutment with, said first (88) and second expansion blocks (90).

29. The press of claim 28 characterized in that the guide means (92) is fabricated of a metal having a thermal coefficient of expansion equal to the thermal coefficient of expansion of said first (88) and second blocks (90).

30. The press of claim 28, characterized in that the guide means (92) is fabricated of a metal having a thermal coefficient of expansion greater than the thermal coefficient of expansion of said first (88) and second blocks (90).

## Claims for the Contracting State: CH

1. A method for thermo-compression diffusion bonding a structured copper strain buffer (12) to a substrateless semiconductor device wafer (16) having two major opposed surfaces, said strain buffer including a bundle of substantially parallel, closely packed strands (40) of copper of substantially equal length, one common end of said strands being thermo-compression diffusion bonded to a metallic sheet (14), said method characterized by the steps of:

applying a first metallic layer (21) to one of said major surfaces;

applying a second metallic layer (23) to said first metallic layer;

positioning the common end of the strands (40) of said strain buffer (12) opposite said metallic sheet (14) in abutment with said second metallic layer;

surrounding the semiconductor device wafer (16) and strain buffer with an inert atmosphere;

applying a loading force to squeeze together at high pressure, said semiconductor device wafer and said strain buffer; and

heating said semiconductor device wafer and said strain buffer at a temperature within the range of 300°C to 400°C while said loading force is applied.

2. A method according to claim 1 characterized by the steps of:

applying first (31) and second metallic layers (37), respectively, over the first (16a) and second major opposed surfaces (16b) of said semiconductor device wafer (16);

applying first (34) and second metallizations (36), respectively, over said first and second metallic layers;

sandwiching said semiconductor device wafer between said first (12) and second structured copper strain buffers (74), the surface of each structured copper strain buffer opposite the respective metallic sheet (42, 52) thereof being positioned facing said wafer, said structured copper strain buffers each having a lateral extent greater than the lateral extent of said semiconductor device wafer and being so positioned as to overhang the entire outer edge surface (16c) of said semiconductor device wafer.

3. A method according to claims 1 or 2 characterized by positioning in abutment with a flat reference surface (20a) of a rigid member (20) the surface of the semiconductor device wafer (16) opposite the wafer surface having the first (21) and second metallic layers (23) disposed thereon.

4. The method of claims 1 or 3 characterized in that the rigid member (20) is comprised of quartz.

5. A method according to claim 1 characterized in that the first (16a) and second major opposed surfaces (16b) of unequal lateral extents and a beveled outer edge surface (16c); coating said beveled surface with a passivation material (82); sandwiching said semiconductor device wafer between and in axial alignment with said first (12') and second structured copper strain buffers (74), each of said structured copper strain buffers having a lateral extent equal to or less than the lateral extent of the respective major surface of said semiconductor device wafer in contact therewith such that said beveled edge remains uncovered by either of said structured copper strain buffers, the common end of the copper strands (40', 50) of each of said first and second structured copper strain buffers opposite the respective metallic sheet (42', 52) thereof being positioned facing said semiconductor device wafers (16); applying a loading force to selected portions of said first and second structured copper strain buffers to squeeze said first and second structured copper strain buffers and said semiconductor device wafer together at high pressure, the selected portion of said first structured copper strain buffer being substantially of identical geometrical size and shape as, and substantially rotationally and axially aligned with, the selected portion of said second structured copper strain buffer.

6. The method of claim 5 characterized by the step of situating first (54) and second layers (56) of non-reactive compactible material in contact with the metallic sheets (42, 52) of said first (12) and second structured copper strain buffers (74), respectively, prior to surrounding said semiconductor device wafer (16) and structured copper strain buffers with an inert atmosphere.

7. A method according to claim 4 characterized in that the first major surface (16a) being smaller than said second major surface (16b), said first structured copper strain buffer (12') being situated on said first surface and having a lateral extent no greater than the lateral extent of said first major surface, said second structured copper strain buffer (74) having a lateral extent at least equal to the lateral extent of said second surface.

8. The method of claims 1 or 3 or 4 or 5 characterized in that the first metallic layer (21) is comprised of one of the group consisting of titanium, chromium and nickel and said second metallic layer (23) is comprised of one of the group consisting of copper, silver and gold.

9. The method of claims 2 or 5 characterized in that the first (31) and second metallic layers (37) are comprised of one of the group consisting of titanium, chromium and nickel, and said first (34) and second metallizations (36) are comprised of one of the group consisting of copper, silver and gold.

10. The method of claim 4 characterized in that the rigid member (20), said semiconductor device wafer (16) and said strain buffer (12) are heated at approximately 325°C for a time within the range of approximately 15 minutes to 3 hours while said rigid member, said semiconductor device wafer and said strain buffer are being squeezed together.

11. The method of claims 1 or 3 or 4 or 5 or 8 characterized by the step of positioning a layer (32) of nonreactive compactible material in abutment with the metallic sheet (14) of said structured copper strain buffer (12) prior to application of said loading force.

12. The method of claim 11 characterized in that the layer (32) of compactible material, said rigid member (20), said semiconductor device wafer (16) and said strain buffer (12) are heated at approximately 325°C for a time within the range of approximately 15 minutes to 3 hours while said layer of compactible material, said rigid member, said semiconductor device wafer and said strain buffer are being squeezed together.

13. The method of claims 1 or 2 or 9 characterized by the step of positioning first (54) and second layers (56) of nonreactive compactible material in abutment, respectively, with the metallic sheets (42, 52) of said first (12) and second structured copper strain buffers (74), prior to application of said loading force.

14. The method of claim 2 characterized by the step of beveling the outer edge of said semiconductor device wafer to form a beveled edge surface (16c) prior to sandwiching said semiconductor device wafer between said first (12) and second structured copper strain buffers (74), said first structured copper strain buffer being positioned facing said beveled surface.

15. The method of claim 14 characterized by the step of applying said first (31) and second metallic layers (37) comprises depositing first and second metallic layers having a lateral extent less than the lateral extent of said wafer (16) and sufficiently small so as to avoid overlapping said beveled surface (16c), said first and second metallic layers being axially aligned with each other.

16. The method of claim 15 characterized by the step of applying said first (34) and second metallizations (36) comprises depositing said first and second metallizations in such manner that said metallizations are axially aligned with said metallic layers (31, 37) and have a lateral extent equal to the lateral extent of said metallic layers.

17. The method of claim 14 characterized by the step of cutting (64) with a laser beam the metallic sheet (42) of said first structured copper strain buffer (12) in a manner allowing removal of most of the portion of said first structured copper strain buffer not bonded to said semiconductor device wafer (16) after heating said wafer.

18. The method of claim 17 characterized by the step of sputter etching said beveled edge surface (16c) of said semiconductor device wafer after cutting said metallic sheet.

19. The method of claim 18 characterized by the step of passivating said beveled edge after sputter etching said beveled edge.

20. The method of any one of the preceding claims characterized in that the high pressure is within the range of approximately 1380 to 3450 bar.

21. The method of any one of the preceding claims characterized by the step of smoothing said first and second major opposed surfaces prior to applying said first (21) and second metallic layers (23) thereon, respectively.

22. The method of any one of the preceding claims characterized by the step of smoothing is accomplished by polishing said first and second major opposed surfaces.

23. The method of any one of the preceding claims characterized by the step of smoothing is accomplished by etching said first and second major opposed surfaces.

24. A press (10) for diffusion bonding metallic surfaces of an assembly together, comprising a first metallic plate means (22) having a predetermined thermal coefficient of expansion, second metallic plate means (24) having a predetermined thermal coefficient of expansion, said second plate means oriented parallel to said first plate means and spaced apart therefrom so as to accept said assembly between said first and second plate means, and metallic support means (28, 30) connecting said first plate means to said second plate means, said support means (28, 30) having a thermal coefficient of expansion selected to restrict the thermal expansion thereof to a value less than the total thermal expansion in thickness of said first and second plate means when said press is heated to an elevated temperature, whereby equal pressures may be exerted on the metallic surfaces of said assembly to squeeze said surfaces together at high pressure when said press is heated to an elevated temperature, characterized by first (88a) and second raised portions (90a) included in and extending from said first (22) and second metallic plate means (24), respectively, toward each other, each raised portion including a flat surface having a selected geometric pattern, the geometric patterns of said first and second raised portions being substantially identical and axially and rotationally aligned with each other, each said flat surface being substantially parallel to the other.

25. The press of claim 24 characterized in that the first and second plate means include first (22) and second plates (24), respectively, and first (88) and second expansion blocks (90) facing each other and attached, respectively, to said first and second plates, said first and second expansion blocks respectively, including said first (88a) and second raised portions (90a).

26. The press of claim 25 wherein said first (88) and second expansion blocks (90) are fabricated of material having thermal coefficients of expansion equal to the thermal coefficient of expansion of said first (22) and second plate means (24).

27. The press of claims 25 or 26 characterized in that the first (88) and second expansion blocks (90) are fabricated of material having thermal coefficients of expansion greater than the thermal coefficient of expansion of said first (22) and second plate means (24).

28. The press of claims 25 or 26 or 27 characterized by guide means (92) extending from said first expansion block (88) to said second expansion block (90) for axially aligning said first (88a) and second raised portions (90a).

29. The press of claim 28 characterized in that the guide means comprises a metallic cylinder (92) surrounding, and in abutment with, said first (88) and second expansion blocks (90).

30. The press of claim 29 characterized in that the guide means (92) is fabricated of a metal having a thermal coefficient of expansion equal to the thermal coefficient of expansion of said first (88) and second blocks (90).

31. The press of claim 29 characterized in that the guide means (92) is fabricated of a metal having a thermal coefficient of expansion greater than the thermal coefficient of expansion of said first (88) and second blocks (90).

**Patentansprüche fur die Vertragsstaaten DE, FR, GB, SE**

1. Verfahren zum Diffusionsverbinden mittels Thermokompression von einem Spannungspuffer (12) aus strukturiertem Kupfer mit einer Halbleiterelementscheibe (16) ohne Substrat, die zwei gegenüberliegende Hauptoberflächen aufweist, wobei der Spannungspuffer ein Bündel im wesentlichen paralleler, dicht gepackter Stränge (40) auf Kupfer im wesentlichen gleicher Länge einschließt, deren eines gemeinsames Endstück durch Thermokompression mit einem Metallblech (14) diffusionsverbunden ist, mit den folgenden Stufen:

Aufbringen einer ersten Metallschicht (21) auf eine der genannten Hauptoberflächen,

Aufbringen einer zweiten Metallschicht (23) auf die genannte erste Metallschicht,

Anordnen des gemeinsamen Endes der Stränge des genannten Spannungspuffers, der eine seitliche Ausdehnung hat, die zumindest gleich der der Oberflächen der genannten Scheibe ist, so gegenüber dem genannten Metallblech, daß diese Enden an die zweite Metallschicht anstoßen,

Umgeben der Halbleiterscheibe und des Spannungspuffers mit einer inerten Atmosphäre,

Ausüben einer belastenden Kraft auf die Halbleiterscheibe und den Spannungspuffer, um sie unter einem hohen Druck zusammenzupressen, und

Erhitzen von Halbleiterscheibe und Spannungspuffer auf eine Temperatur im Bereich von 300 bis 400°C, währen die belastende Kraft ausgeübt wird.

2. Verfahren nach Anspruch 1, gekennzeichnet durch die folgenden Stufen:

Aufbringen einer ersten (31) bzw. zweiten Metallschicht (37) auf die erste (16a) bzw. zweite gegenüberliegende Hauptoberfläche (16b) der Halbleiterscheibe (16),

Aufbringen einer ersten (34) bzw. zweiten Metallisierung (36) auf die erste bzw. zweite Metallschicht,

Anordnen der Halbleiterscheibe zwischen einem ersten (12) un einem zweiten Spannungspuffer (74) aus strukturiertem Kupfer, wobei der Oberfläche jedes der Spannungspuffer gegenüber dem jeweiligen Metallblech (42, 52) so angeordnet wird, daß sie der Halbleiterscheibe gegenüber liegt, wobei die Spannungspuffer aus strukturiertem Kupfer je eine seitliche Ausdehnung haben, die die seitliche Ausdehnung der Halbleiterscheibe übersteigt, und die Puffer so angeordnet werden, daß sie über die gesamte Außenkantenoberfläche (16c) der Halbleiterscheibe hinausragen.

3. Verfahren nach Anspruch 1 oder 2, dadurch gekennzeichnet, daß die Oberfläche der Halbleiterelementscheibe (16), die der Scheibenoberfläche gegenüberliegt, auf der die erste (21) and zweite Metallschicht (23) angeordnet sind, so angeordnet wird, daß sie an einer flachen Bezugsoberfläche (20a) eines starren Teiles (20) anliegt.

4. Verfahren nach Anspruch 1 oder 3, dadurch gekennzeichnet, daß das starre Teil (20) aus Quarz besteht.

5. Verfahren nach Anspruch 1, dadurch gekennzeichnet, daß die erste (16a) und die zweite gegenüberliegende Hauptoberfläche (16b) ungleiche seitliche Ausdehnungen sowie eine abgeschrägte Außenkantenoberfläche (16c) aufweisen,

daß diese abgeschrägte Oberfläche mit einem Passivierungsmaterial (82) überzogen wird,

daß die Halbleiterscheibe zwischen dem ersten (12') und dem zweiten Spannungspuffer (74) aus strukturiertem Kupfer und in axialer Ausrichtung damit angeordnet wird, wobei jeder Spannungspuffer eine seitliche Ausdehnung hat, die zumindest gleich der seitlichen Ausdehnung der jeweiligen Hauptoberfläche der Halbleiterelementscheibe ist, mit der sie sich in Kontakt befindet, so daß die abgeschrägte Kante von dem Spannungspuffern unbedeckt bleibt,

das gemeinsame Ende der Kupferstränge (40', 50) jedes der beiden Spannungspuffer gegenüber dem jeweiligen Metallbleich (42', 52) so angeordnet wird, daß es den Halbleiterelementscheiben (16) gegenüberliegt,

daß man eine Belastungskraft auf ausgewählte Abschnitte des ersten und zweiten Spannungspuffers ausübt, um diese und die Halbleiterscheibe unter hohem Druck zusammenzupressen, wobei der ausgewählte Abschnitt des ersten Spannungspuffers von im wesentlichen identischer geometrischer Größe und Gestalt wie der ausgewählte Abschnitt des zweiten Spannungspuffers ist un mit diesem im wesentlichen rotationsmäßig und axial ausgerichtet ist.

6. Verfahren nach Anspruch 5, gekennzeichnet durch die Stufe des Anordnens einer ersten (54) bzw. zweiten Schicht (56) aus nichtreaktivem zusammenpreßbaren Material in Kontakt mit den Metallblechen (42, 52) des ersten (12) bzw. zweiten Spannungspuffers (74) aus strukturiertem Kupfer, bevor man die Halbleiterelementscheibe (16) und die Spannungspuffer mit einer inerten Atmosphäre umgibt.

7. Verfahren nach Anspruch 4, dadurch gekennzeichnet, daß die erste Hauptoberfläche (16a) kleiner ist als die zweite Hauptoberfläche (16b), daß der erste Spannungspuffer (12') aus strukturiertem Kupfer auf der genannten ersten Hauptoberfläche angeordnet ist und eine seitliche Ausdehnung hat, die nicht größer ist als die seitliche Ausdehnung der ersten Hauptoberfläche, und daß der zweite Spannungspuffer (74) eine seitliche Ausdehnung hat, die mindestens gleich der seitlichen Ausdehnung der zweiten Hauptoberfläche ist.

8. Verfahren nach Anspruch 1 oder 3 oder 4 oder 5, dadurch gekennzeichnet, daß die erste Metallschicht (21) aus einem Metall aus der Gruppe aus Titan, Chrom und Nickel, und die zweite Metallschicht (23) aus einem Metall aus der Gruppe aus Kupfer, Silber und Gold zusammengesetzt ist.

9. Verfahren nach Anspruch 2 oder 5, dadurch gekennzeichnet, daß die erste (31) und die zweite Metallschicht (37) aus einem Metall aus der Gruppe aus Titan, Chrom und Nickel zusammengesetzt sind und daß die erste (34) und die zweite Metallisierung (36) aus einem Metall aus der Gruppe aus Kupfer, Silber und Gold zusammengesetzt sind.

10. Verfahren nach Anspruch 4, dadurch gekennzeichnet, daß das starre Teil (20), die Halbleiterelementscheibe (16) und der Spannungspuffer (12) für eine Dauer im Bereich von etwa 15 Minuten bis zu 3 Stunden auf eine Temperatur von etwa 325°C erhitzt werden, während das genannte starre Teil, die genannte Halbleiterscheibe und der genannte Spannungspuffer zusammengepreßt werden.

11. Verfahren nach Anspruch 1 oder 3 oder 4 oder 5 oder 8, dadurch gekennzeichnet, daß vor dem Ausüben der Belastungskraft eine Schicht (32) aus einem nicht-reaktiven, zusammenpreßbaren Material an dem Metallblech (14) des Spannungspuffers (12) aus strukturiertem Kupfer anstoßend angeordnet wird.

12. Verfahren nach Anspruch 11, dadurch gekennzeichnet, daß die Schicht (32) aus zusammenpreßbarem Material, das starre Teil (20), die Halbleiterelementscheibe (16) und der Spannungspuffer (12) für eine Dauer im Bereich von etwa 15 Minuten bis zu 3 Stunden auf etwa 325°C erhitzt werden, während das genannte starre Teil, die genannte Halbleiterscheibe und der genannte Spannungspuffer zusammengepreßt werden.

13. Verfahren nach Anspruch 1 oder 2 oder 9, gekennzeichnet durch die Stufe des Anordnens einer ersten (54) bzw. einer zweiten Schicht (56) aus einem nicht-reaktiven, zusammenpreßbaren Material an die Metallbleche (42, 52) des ersten (12) bzw. zweiten Spannungspuffers (74) aus strukturiertem Kupfer anstoßend vor dem Ausüben der Belastungskraft.

14. Verfahren nach Anspruch 2, gekennzeichnet durch die Stufe des Abschrägens der Außenkante der Halbleiterelementscheibe unter Bildung einer abgeschrägten Kantenoberfläche (16c) vor dem Anordnen dieser Scheibe zwischen dem ersten (12) und dem zweiten Spannungspuffer (74), wobei der erste Spannungspuffer aus strukturiertem Kupfer so angeordnet wird, daß er dieser abgeschrägten Oberfläche gegenüberliegt.

15. Verfahren nach Anspruch 14, dadurch gekennzeichnet, daß die Stufe des Aufbringens der ersten (31) und der zweiten Metallschicht (37) das Abscheiden einer ersten und einer zweiten Metallschicht mit einer seitlichen Ausdehnung umfaßt, die geringer ist als die seitliche Ausdehnung der Halbleiterscheibe (16), und daß die seitliche Ausdehnung der Metallschichten gering genug ist, daß sie die abgeschrägte Oberfläche (16c) nicht überlappen, wobei die erste und die zweite Metallschicht axial miteinander ausgerichtet sind.

16. Verfahren nach Anspruch 15, dadurch gekennzeichnet, daß die Stufe des Aufbringens der ersten (34) und der zweiten Metallisierung (36) das Abscheiden der ersten und der zweiten Metallisierung in einer solchen Weise umfaßt, daß die Metallisierungen axial mit den Metallschichten (31, 37) ausgerichtet sind und daß sie eine seitliche Ausdehnung haben, die gleich der seitlichen Ausdehnung der Metallschichten ist.

17. Verfahren nach Anspruch 14, gekennzeichnet durch die Stufe des Schneidens (64) des Metallbleches (42) der ersten Spannungspuffers (12) aus strukturiertem Kupfer mit einem Laserstrahl derart, daß der größte Teil des ersten Spannungspuffers, der nach dem Erhitzen der Scheibe nicht mit der Halbleiterelementscheibe (16) verbunden ist, entfernt werden kann.

18. Verfahren nach Anspruch 17, gekennzeichnet durch die Stufe des Zerstäubungsätzens der abgeschrägten Kantenoberfläche (16c) der Halbleiterelementscheibe nach dem Schneiden des Metallbleches.

19. Verfahren nach Anspruch 18, gekennzeichnet durch die Stufe des Passivierens der abgeschrägten Kante nach dem Zerstäubungsätzen.

20. Verfahren nach irgendeinem der vorhergehenden Ansprüche, dadurch gekennzeichnet, daß der hohe Druck im Bereich von etwa 1380 bis etwa 3450 bar liegt.

21. Verfahren nach irgendeinem der vorhergehenden Ansprüche, gekennzeichnet durch die Stufe des Glättens der ersten und der zweiten Hauptoberfläche der Halbleiterscheibe vor dem Aufbringen der ersten (21) bzw. der zweiten Metallschicht (23) darauf.

22. Verfahren nach irgendeinem der vorhergehenden Ansprüche, dadurch gekennzeichnet, daß die Stufe des Glättens durch Polieren der ersten und der zweiten Hauptoberfläche ausgeführt wird.

23. Verfahren nach irgendeinem der vorhergehenden Ansprüche, dadurch gekennzeichnet, daß die Stufe des Glättens durch Ätzen der ersten und der zweiten Hauptoberfläche ausgeführt wird.

24. Presse (10) zum Diffusionsverbinden metallischer Oberflächen einer Baueinheit miteinander mit einer ersten Metallplatteneinrichtung (22) mit einem vorbestimmten thermischen Ausdehnungskoeffizienten, einer zweiten Metallplatteneinrichtung (24) mit einem vorbestimmten thermischen Ausdehnungkoeffizienten, wobei die zweite Metallplatteneinrichtung parallel zur ersten Metallplatteneinrichtung und im Abstand davon angeordnet ist, um die Baueinheit dazwischen aufzunehmen, und metallischen Trägereinrichtungen (28, 30') die die erste Platteneinrichtung mit der zweiten Platteneinrichtung verbinden, wobei die Trägereinrichtung einen thermischen Ausdehnungskoeffizienten hat, der so ausgewählt ist, daß die thermische Ausdehnung der Trägereinrichtung auf einen Wert beschränkt ist, der geringer ist als die gesamte thermische Dickenausdehnung der ersten und der zweiten Platteneinrichtung, wenn die Presse auf eine erhöhte Temperatur erhitzt wird, wodurch gleiche Drucke auf die Metalloberflächen der Baueinheit ausgeübt werden können, um diese Oberflächen unter einem hohen Druck zusammenzupressen, wenn die Presse auf eine erhöhte Temperatur erhitzt wird, einem ersten (88) bzw. einem zweiten Ausdehnungsblock (90), die einander gegenüberstehen und an der ersten bzw. zweiten Platteneinrichtung angebracht sind, wobei der erste bzw. der zweite Ausdehnungsblock eine erste (88a) bzw. eine zweite Erhebung (90a) einschließt, die sich aufeinanderzu erstrecken, wobei jede Erhebung eine flache Oberfläche mit einem ausgewählten geometrischen Muster hat, die geometrischen Muster der ersten und der zweiten Erhebung im wesentlichen identisch und axial sowie rotationsmäßig miteinander ausgerichtet sind und die flachen Oberflächen der Erhebungen im wesentlichen parallel zueinander liegen.

25. Presse nach Anspruch 24, dadurch gekennzeichnet, daß der erste (88) und der zweite Ausdehnungsblock (90) aus einem Material hergestellt sind, dessen thermischer Ausdehnungskoeffizient gleich dem thermischen Ausdehnungskoeffizienten der ersten (22) und der zweiten Platteneinrichtung (24) ist.

26. Presse nach Anspruch 24 oder 25, dadurch gekennzeichnet, daß der erste (88) und der zweite Ausdehnungsblock (90) aus einem Material hergestellt sind, dessen thermischer Ausdehnungskoeffizient größer ist als der thermische Ausdehnungskoeffizient der ersten (22) und der zweiten Platteneinrichtung (24).

27. Presse nach Anspruch 24 oder 25 oder 26, gekennzeichnet durch eine Führungseinrichtung (92), die sich von dem ersten Ausdehnungsblock (88) aus zum zweiten Ausdehnungsblock (90) erstreckt, um die erste (88a) und die zweite Erhebung (90a) auszurichten.

28. Presse nach Anspruch 27, dadurch gekennzeichnet, daß die Führungseinrichtung einen Metallzylinder (92) umfaßt, der den ersten (88) und den zweiten Ausdehnungsblock (90) umgibt und an diesem anliegt.

29. Presse nach Anspruch 28, dadurch gekennzeichnet, daß die Führungseinrichtung (92) aus einem Metall hergestellt ist, dessen thermischer Ausdehnungskoeffizient gleich dem thermischen Ausdehnungskoeffizienten des ersten (88) und zweiten Ausdehnungsblockes (90) ist.

30. Presse nach Anspruch 28, dadurch gekennzeichnet, daß die Führungseinrichtung (92) aus einem Metall hergestellt ist, dessen thermischer Ausdehnungskoeffizient größer ist als der thermische Ausdehnungskoeffizient des ersten (88) und zweiten Ausdehnungsblocks (90).

**Patentansprüche für den Vertragsstaat: CH**

1. Verfahren zum Diffusionsverbinden mittels Thermokompression von einem Spannungspuffer (12) aus strukturiertem Kupfer mit einer Halbleiterelementscheibe (16) ohne Substrat, die zwei gegenüberliegende Hauptoberflächen aufweist, wobei der Spannungspuffer ein Bündel in wesentlichen paralleler, dicht gepackter Stränge (40) aus Kupfer im wesentlichen gleicher Länge einschließt, deren gemeinsames Endstück durch Thermokompression mit einem Metallblech (14) diffusionsverbunden ist, gekennzeichnet durch die folgenden Stufen:

Aufbringen einer ersten Metallschicht (21) auf eine der genannten Hauptoberflächen,

Aufbringen einer zweiten Metallschicht (23) auf die genannte erste Metallschicht,

Anordnen des gemeinsamen Endes der Stränge (40) des genannten Spannungspuffers (12) so gegenüber dem genannten Metallblech (14), daß diese Enden an die zweite Metallschicht anstoßen,

Umgeben der Halbleiterscheibe (16) und des Spannungspuffers mit einer inerten Atmosphäre,

Ausüben einer belastenden Kraft auf die Halbleiterscheibe und den Spannungspuffer, um sie unter einem hohen Druck zusammenzupressen, und

Erhitzen von Halbleiterscheibe und Spannungspuffer auf eine Temperatur im Bereich von 300 bis 400°C, während die belastende Kraft aufgeübt wird.

2. Verfahren nach Anspruch 1, gekennzeichnet durch die folgenden Stufen:

Aufbringen einer ersten (31) bzw. zweiten Metallschicht (37) auf die erste (16a) bzw. die zweite gegenüberliegende Hauptoberfläche (16b) der Halbleiterscheibe (16),

Aufbringen einer ersten (34) bzw. zweiten Metallisierung (36) auf die erste bzw. zweite Metallschicht,

Anordnen der Halbleiterscheibe zwischen einem ersten (12) und einem zweiten Spannungspuffer (74) aus strukturiertem Kupfer, wobei die Oberfläche jedes der Spannungspuffer gegenüber dem jeweiligen Metallblech (42, 52) so angeordnet wird, daß sie der Halbleiterscheibe gegenüberliegt, wobei die Spannungspuffer aus strukturiertem Kupfer je eine seitliche Ausdehnung haben, die die seitliche Ausdehnung der Halbleiterscheibe übersteigt, und die Puffer so angeordnet werden, daß sie über die gesamte Außenkantenoberfläche (16c) der Halbleiterscheibe hinausragen.

3. Verfahren nach Anspruch 1 oder 2, dadurch gekennzeichnet, daß die Oberfläche der Halbleiterelementscheibe (16), die der Scheibenoberfläche gegenüberliegt, auf der die erste (21) und zweite Metallschicht (23) angeordnet sind, so angeordnet wird, daß sie an einer flachen Bezugsoberfläche (20a) eines starren Teiles (20) anliegt.

4. Verfahren nach Anspruch 1 oder 3, dadurch gekennzeichnet, daß das starre Teil (20) aus Quarz besteht.

5. Verfahren nach Anspruch 1, dadurch gekennzeichnet, daß die erste (16a) und die zweite gegenüberliegende Hauptoberfläche (16b) ungleiche seitliche Ausdehnungen sowie eine abgeschrägte Außenkantenoberflache (16c) aufweisen,

daß diese abgeschrägte Oberfläche mit einem Passivierungsmaterial (82) überzogen wird,

daß die Halbleiterscheibe zwischen dem ersten (12') und dem zweiten Spannungspuffer (74) aus strukturiertem Kupfer und in axialer Ausrichtung damit angeordnet wird, wobei jeder der Spannungspuffer eine seitliche Ausdehnung hat, die gleich oder geringer ist als sie seitliche Ausdehnung der jeweiligen Hauptoberfläche der Halbleiterelementscheibe, mit der sie sich in Kontakt befindet, so daß die abgeschrägte Kante von den Spannungspuffern unbedeckt bleibt,

das gemeinsame Ende der Kupferstänge (40', 50) jedes der beiden Spannungspuffer gegenüber dem jeweiligen Metallbleich (42', 52) so angeordnet wird, daß es den Halbleiterelement scheiben (16) gegenüberliegt,

daß man eine Belastungskraft auf ausgewählte Abschnitte des ersten und zweiten Spannungspuffers ausübt, um diese und die Halbleiterscheibe unter hohem Druck zusammenzupressen, wobei der ausgewählte Abschnitt des ersten Spannungspuffers von im wesentlichen identischer geometrischer Größe Gestalt wie der ausgewählte Abschnitt des zweiten Spannungspuffers ist und mit diesem im wesentlichen rotationsmäßig und axial ausgerichtet ist.

6 Verfahren nach Anspruch 5, gekennzeichnet durch die Stufe des Anordnens einer ersten (54) bzw. zweiten Schicht (56) aus nichtreaktivem zusammenpreßbaren Material in Kontakt mit den Metallblechen (42, 52) des ersten (12) bzw. zweiten Spannungspuffers (74) aus strukturiertem Kupfer, bevor man die Halbleiterelementscheibe (16) und die Spannungspuffer mit einer inerten Atmosphäre umgibt.

7. Verfahren nach Anspruch 4, dadurch gekennzeichnet, daß die erste Hauptoberfläche (16a) kleiner ist als die zweite Hauptoberfläche (16b) daß der erste Spannungspuffer (12') aus strukturiertem Kupfer auf der genannten ersten Hauptoberfläche angeordnet ist und eine seitliche Ausdehnung hat, die nicht größer ist als die seitliche Ausdehnung der ersten Hauptoberfläche, und daß der zweite Spannungspuffer (74) eine seitliche Ausdehnung hat, die mindestens gleich der seitlichen Ausdehnung der zweiten Hauptoberfläche ist.

8. Verfahren nach Anspruch 1 oder 3 oder 4 oder 5, dadurch gekennzeichnet, daß die erste Metallschicht (21) aus einem Metall aus der Gruppe aus Titan, Chrom und Nickel, und die zweite Metallschicht (23) aus einem Metall aus der Gruppe aus Kupfer, Silber und Gold zusammengesetzt ist.

9. Verfahren nach Anspruch 2 oder 5, dadurch gekennzeichnet, daß die erste (31) und die zweite Metallschicht (37) aus einem Metall aus der Gruppe aus Titan, Chrom und Nickel zusammengesetzt sind, und daß die erste (34) und die zweite Metallisierung (36) aus einem Metall aus der Gruppe aus Kupfer, Silber und Gold zusammengezetzt sind.

10. Verfahren nach Anspruch 4, dadurch gekennzeichnet, daß das starre Teil (20), die Halbleiterelementscheibe (16) und der Spannungspuffer (12) für eine Dauer im Bereich von etwa 15 Minuten bis zu 3 Stunden auf eine Temperatur von etwa 325°C erhitzt werden, während das genannte starre Teil, die genannte Halbleiterscheibe und der genannte Spannungspuffer zusammengepreßt werden.

11. Verfahren nach Anspruch 1 oder 3 oder 4 oder 5 oder 8, dadurch gekennzeichnet, daß vor dem Ausüben der Belastungskraft eine Schicht (32) aus einem nicht-reaktiven, zusammenpreßbaren Material an dem Metallblech (14) des Spannungspuffers (12) aus strukturiertem Kupfer anstoßend angeordnet wird.

12. Verfahren nach Anspruch 11, dadurch gekennzeichnet, daß die Schicht (32) aus zusammenpreßbaren Material, das starre Teil (20), die Halbleiterelementscheibe (16) und der Spannungspuffer (12) für eine Dauer im Bereich von etwa 15 Minuten bis zu 3 Stunden auf etwa 325°C erhitzt werden, während das genannte starre Teil, die genannte Halbleiterscheibe und der genannte Spannungspuffer zusammengepreßt werden.

13. Verfahren nach Anspruch 1 oder 2 oder 9, gekennzeichnet durch die Stufe des Anordnens einer ersten (54) bzw. einer zweiten Schicht (56) aus einem nichtreaktiven, zusammenpreßbaren Material an die Metallbleche (42, 52) des ersten (12) und des zweiten Spannungspuffers (74) aus strukturiertem Kupfer anstoßend vor dem Ausüben der Belastungskraft.

14. Verfahren nach Anspruch 2, gekennzeichnet durch die Stufe des Abschrägens der Außenkante der Halbleiterelementscheibe unter Bildung einer abgeschrägten Kantenoberfläche (16c) vor dem Anordnen dieser Scheibe zwischen dem ersten (12) und dem zweiten Spannungspuffer (74), wobei der erste Spannungspuffer aus strukturiertem Kupfer so angeordnet wird, daß er dieser abgeschrägten Oberfläche gegenüberliegt.

15. Verfahren nach Anspruch 14, dadurch gekennzeichnet, daß die Stufe des Aufbringens der ersten (31) und der zweiten Metallschicht (37) das Abscheiden einer ersten und einer zweiten Metallschicht mit einer seitlichen Ausdehnung umfaßt, die geringer ist als die seitliche Ausdehnung der Halbleiterscheibe (16), und daß die seitliche Ausdehnung der Metallschichten gering genung ist, daß sie die abgeschrägte Oberfläche (16c) nicht überlappen, wobei die erste und die zweite Metallschicht axial miteinander ausgerichtet sind.

16. Verfahren nach Anspruch 15, dadurch gekennzeichnet, daß die Stufe des Aufbringens der ersten (34) und der zweiten Metallisierung (36) das Abscheiden der ersten und der zweiten Metallisierung in einer solchen Weise umfaßt, daß die Metallisierungen axial mit dem Metallschichten (31, 37) ausgerichtet sind und daß die eine seitliche Ausdehnung haben, die gleich der seitlichen Ausdehnung der Metallschichten ist.

17. Verfahren nach Anspruch 14, gekennzeichnet durch die Stufe des Schneidens (64) des Metallbleches (42) des ersten Spannungspuffers (12) aus strukturiertem Kupfer mit einem Laserstrahl derart, daß der größte Teil des ersten Spannungspuffers, der nach dem Erhitzen der Scheibe nicht mit der Halbleiterelementscheibe (16) verbunden ist, entfernt werden kann.

18. Verfahren nach Anspruch 17, gekennzeichnet durch die Stufe des Zerstäubungsätzens der abgeschrägten Kantenoberfläche (16c) der Haltleiterelementscheibe nach dem Schneiden des Metallbleches.

19. Verfahren nach Anspruch 18, gekennzeichnet durch die Stufe des Passivierens der abgeschrägten Kante nach dem Zerstäubungsätzen.

20. Verfahren nach irgendeinem der vorhergehenden Ansprüche, dadurch gekennzeichnet, daß der hohe Druck im Bereich von etwa 1380 bis etwa 3450 bar liegt.

21. Verfahren nach irgendeinem der vorhergehenden Ansprüche, gekennzeichnet durch die Stufe des Glättens der ersten und der zweiten Hauptoberfläche der Halbleiterscheibe vor dem Aufbringen der ersten (21) bzw. der zweiten Metallschicht (23) darauf.

22. Verfahren nach irgendeinem der vorhergehenden Ansprüche, dadurch gekennzeichnet, daß die Stufe des Glättens durch Polieren der ersten und der zweiten Hauptoberfläche ausgeführt wird.

23. Verfahren nach irgendeinem der vorhergehenden Ansprüche, dadurch gekennzeichnet, daß die Stufe des Glättens durch Ätzen der ersten und der zweiten Hauptoberfläche ausgeführt wird.

24. Presse (10) zum Diffusionsverbinden metallischer Oberflächen einer Baueinheit miteinander mit einer ersten Metallplatteneinrichtung (22) mit einem vorbestimmten thermischen Ausdehnungskoeffizienten, einer zweiten Metallplatteneinrichtung (24) mit einem vorbestimmten thermischen Ausdehnungskoeffizienten, wobei die zweite Metallplatteneinrichtung parallel zur ersten Metallplatteneinrichtung und im Abstand davon angeordnet ist, um die Baueinheit dazwischen aufzunehmen, und metallischen Trägereinrichtungen (28, 30), die die erste Platteneinrichtung mit der zweiten Platteneinrichtung verbinden, wobei die Trägereinrichtungen (28, 30) einen thermischen Ausdehnungskoeffizienten haben, der so ausgewählt ist, daß die thermische Ausdehnung der Trägereinrichtungen auf einen Wert beschränkt ist, der geringer ist als die gesamte thermische Dickenausdehnung der ersten und der zweiten Platteneinrichtung, wenn die Presse auf eine erhöhte Temperatur erhitzt wird, wodurch gleiche Drucke auf die Metalloberflächen der Baueinheit ausgeübt werden können, um diese Oberflächen unter einem hohen Druck zusammenzupressen, wenn die Presse auf eine erhöhte Temperatur erhitzt wird, gekennzeichnet durch eine erste (88a) und eine zweite Erhebung (90a), die sich von der ersten (22) und der zweiten Metallplatteneinrichtung (24) aus aufeinanderzu erstrecken, wobei jede Erhebung eine flache Oberfläche mit einem ausgewählten geometrischen Muster hat, die geometrischen Muster der ersten und der zweiten Erhebung im wesentlichen identisch und axial sowie rotationsmäßig miteinander ausgerichtet sind und die flachen Oberflächen der Erhebungen im wesentlichen parallel zueinander liegen.

25. Presse nach Anspruch 24, dadurch gekennzeichnet, daß die erste und die zweite Platteneinrichtung erste (22) bzw. zweite Platten (24) und erste (88) und zweite Ausdehnungsblöcke (90) einschließen, die einander gegenüberstehen und an der ersten bzw. zweiten Platte angebracht sind, wobei der erste bzw. der zweite Ausdehnungsblock die erste (88a) bzw. zweite Erhebung (90a) einschließt.

26. Presse nach Anspruch 25, dadurch gekennzeichnet, daß der erste (88) und der zweite Ausdehnungsblock (90) aus einem Material hergestellt, sind, dessen thermischer Ausdehnungskoeffizient gleich dem thermischen Ausdehnungskoeffizienten der ersten (22) und der zweiten Platte (24) ist.

27. Presse nach Anspruch 25 oder 26, dadurch gekennzeichnet, daß der erste (88) und der zweite Ausdehnungsblock (90) aus einem Material hergestellt sind, dessen thermischer Ausdehnungskoeffizient größer ist als der thermische Ausdehnungskoeffizient der ersten (22) und der zweiten Platte (24).

28. Presse nach Anspruch 25 oder 26 oder 27, gekennzeichnet durch eine Fuhrungseinrichtung (92), die sich von dem ersten Ausdehnungsblock (88) aus zum zweiten Ausdehnungsblock (90) erstreckt, um die erste (88a) und die zweite Erhebung (90a) auszurichten.

29. Presse nach Anspruch 28, dadurch gekennzeichnet, daß die Führungseinrichtung einen Metallzylinder (92) umfaßt, der den ersten (88) und den zweiten Ausdehnungsblock (90) umgibt und an diesem anliegt.

30. Presse nach Anspruch 29, dadurch gekennzeichnet, daß die Führungseinrichtung (92) aus einem Metall hergestellt ist, dessen thermischer Ausdehnungskoeffizient gleich dem thermischen Ausdehnungskoeffizienten des ersten (88) und zweiten Ausdehnungsblocks (90) ist.

31. Presse nach Anspruch 29, dadurch gekennzeichnet, daß die Führungseinrichtung (92) aus einem Metall hergestellt ist, dessen thermischer Ausdehnungskoeffizient größer ist als der thermische Ausdehnungskoeffizient des ersten (88) und zweiten Ausdehnungsblocks (90).

**Revendications pour les Etats Contractants:
DE—FR—GB—SE**

1. Un procédé de liaison par diffusion par thermocompression d'un élément tampon d'absorption des contraintes en cuivre structuré (12) sur une tranche de dispositif semiconducteur sans substrat (16) ayant deux surfaces principales opposées, cet élément tampon d'absorption des contraintes comprenant un faisceau de brins de cuivre (40) serrés et pratiquement parallèles, de longueur pratiquement égale, dont une extrémité commune est liée par diffusion par thermocompression à une plaque métallique (14), comprenant les opérations suivantes:

on applique une première couche métallique (21) sur l'une desdites surfaces principales;

on applique une seconde couche métallique (23) sur la première couche métallique;

on place l'extrémité commune des brins de l'élément tampon d'absorption des contraintes, ayant une étendue latérale au moins égale à celle des surfaces de la tranche, qui est opposée à la plaque métallique, contre la seconde couche métallique;

on entoure d'une atmosphère inerte la tranche de dispositif semiconducteur et la mémoire tampon d'absorption des contraintes;

on applique une force destinée à comprimer ensemble avec une pression élevée la tranche de dispositif semiconducteur et l'élément tampon d'absorption des contraintes; et

on chauffe la tranche de dispositif semiconducteur et l'élément tampon d'absorption des contraintes à une température comprise dans la plage de 300°C à 400°C, pendant l'application de ladite force.

2. Un procédé selon la revendication 1, caractérisé par les opérations suivantes:

on applique respectivement des première (31) et seconde (32) couches métalliques sur les première (16a) et seconde (16b) surfaces principales opposées de la tranche de dispositif semiconducteur (16);

on applique respectivement des première (34) et seconde (36) métallisations sur les première et seconde couche métalliques;

on intercale la tranche de dispositif semiconducteur entre la premier élément tampon d'absorption des contraintes en cuivre structuré (12) et un second (74) avec la surface de chaque élément tampon d'absorption des contraintes en cuivre structuré qui est opposée à sa plaque métallique respective (42, 52) placée face à la tranche, chacun de ces éléments tampons d'absorption des contraintes en cuivre structuré ayant une étendue latérale supérieure à l'étendue latérale de la tranche de dispositif semiconducteur et étant placé de façon à surplomber la totalité de la surface de bord extérieure (16c) de la tranche de dispositif semiconducteur.

3. Un procédé selon les revendications 1 ou 2, caractérisé en ce qu'on positionne contre une surface de référence plane (20a) d'un élément rigide (20) la surface de la tranche de dispositif semiconducteur (16) qui est opposée à la surface de la tranche portant des première (21) et seconde (23) couches métalliques.

4. Le procédé des revendications 1 ou 3, caractérisé en ce que l'élément rigide (20) consiste en quartz.

5. Un procédé selon la revendications 1, caractérisé en ce que les première (16a) et seconde (16b) surfaces principales opposées ont des étendues latérales inégales et une surface de bord extérieure biseautée (16c); on revêt la surface biseautée avec une matière de passivation (82); on intercale la tranche de dispositif semiconducteur entre le premier (12') et second (74) éléments tampons d'absorption des contraintes en cuivre structuré, et en alignement axial avec ces éléments, chacun des éléments tampons d'absorption des contraintes en cuivre structuré ayant une étendue latérale au moins égale à l'étendue latérale de la surface latérale respective de la tranche de dispositif semiconducteur en contact avec lui, de façon que le bord biseauté ne soit recouverte par aucun des éléments tampons d'absorption des contraintes en cuivre structuré, l'extrémite commune des brins de cuivre (40°, 50) de chacun des premier et second éléments tampons d'absorption des contraintes en cuivre structuré qui est opposée à la plaque métallique respective (42', 52) de cet élément étant positionnée face à la tranche de dispositif semiconducteur (16); on applique une force à des parties sélectionnées des premier et second éléments tampons d'absorption des contraintes en cuivre structuré, pour comprimer ensemble les premier et second éléments tampons d'absorption des contraintes en cuivre structuré et la tranche de dispositif semiconducteur, avec une pression élevée, la partie sélectionnée du premier élément tampon d'absorption des contraintes en cuivre structuré ayant une taille et une forme géométriques pratiquement identiques à celles de la partie sélectionnée du second élément tampon d'absorption des contraintes en cuivre structuré, et étant pratiquement alignée axialement et en rotation avec la partie sélectionnée du second élément tampon d'absorption des contraintes en cuivre structuré.

6. Le procédé de la revendication 5, caractérisé par l'opération qui consiste à placer des première (54) et seconde (56) couches de matière compressible non réactive en contact avec les plaques métalliques (42, 52) des premier (12) et second (74) éléments tampons d'absorption des contraintes en cuivre structuré respectifs, avant d'entourer d'une atmosphère inerte la tranche de dispositif semiconducteur (16) et les éléments tampons d'absorption des contraintes en cuivre structuré.

7. Un procédé selon la revendication 4, caractérisé en ce que la première surface principale (16a) est plus petite que la seconde surface principale (16b), le premier élément tampon d'absorption des contraintes en cuivre structuré (12') est situé sur la première surface et il a une étendue latérale qui n'est par supérieure à l'étendue latérale de la première surface principale, et le second élément tampon d'absorption des contraintes en cuivre structuré (74) a une étendue latérale au moins égale à l'étendue latérale de la seconde surface.

8. Le procédé selon les revendications 1 ou 3 ou 4 ou 5, caractérisé en ce que la première couche métallique (21) est constituée par l'une des matières du groupe comprenant le titane, le chrome et le nickel, et la seconde couche métallique (23) est constituée par l'une des matières de groupe comprenant le cuivre, l'argent et l'or.

9. Le procédé selon les revendications 2 ou 5, caractérisé en ce que les première (31) et seconde (37) couches métalliques sont constituées par l'une des matières du groupe comprenant le titane, le chrome et le nickel, et les première (34) et seconde (36) métallisations sont constituées par l'une des matières du groupe comprenant le cuivre, l'argent et l'or.

10. Le procédé selon la revendication 4, caractérisé en ce qu'on chauffe l'élément rigide (20), la tranche de dispositif semiconducteur (16) et l'élément tampon d'absorption des contraintes (12) à environ 325°C pendant une durée dans la plage d'environ 15 minutes à 3 heures, pendant qu'on comprime ensemble l'élément rigide, la tranche de dispositif semiconducteur et l'élément tampon d'absorption des contraintes.

11. Le procédé selon les revendications 1 ou 3 ou 4 ou 5 ou 8, caractérisé par l'opération consistant à placer une couche (32) de matière compressible non réactive contre la plaque métallique (14) de l'élément tampon d'absorption des contraintes en cuivre structuré (12), avant l'application de ladite force.

12. Le procédé selon la revendication 11, caractérisé en ce qu'on chauffe la couche (32) de matière compressible, l'élément rigide (20), la tranche de dispositif semiconducteur (16) et l'élément tampon d'absorption des contraintes (12) à environ 325°C pendant une durée comprise dans la plage d'environ 15 minutes à 3 heures, pendant qu'on comprime ensemble la couche de matière compressible, l'élément rigide, la tranche de dispositif semiconducteur et l'élément tampon d'absorption des contraintes.

13. Le procédé selon les revendications 1 ou 2 ou 9, caractérisé par l'opération consistant à positionner des première (54) et seconde (56) couches de matière compressible non réactive respectivement contre les plaques métalliques (42, 52) des premier (12) et second (74) éléments tampons d'absorption des contraintes en cuivre structuré, avant l'application de ladite force.

14. Le procédé selon la revendication 2, caractérisé par l'opération consistant à biseauter le bord extérieur de la tranche de dispositif semiconducteur, pour former une surface de bord biseautée (16c), avant d'intercaler la tranche de dispositif semiconducteur entre les premier (12) et second (74) éléments tampons d'absorption des contraintes en cuivre structuré, avec le premier élément tampon d'absorption des contraintes en cuivre structuré placé face à la surface biseautée.

15. Le procédé selon la revendication 14, caractérisé en ce que l'opération qui consiste à appliquer les première (31) et seconde (37) couches métalliques comprend le dépôt d'une première et d'une seconde couches métalliques ayant une étendue latérale inférieure à l'étendue latérale de la tranche (16), et suffisamment petites pour qu'elles ne recouvrent pas la surface biseautée (16c), ces première et seconde couches métalliques étant mutuellement alignées en direction axiale.

16. Le procédé selon la revendication 15, caractérisé en ce que l'opération qui consiste à appliquer les première (34) et seconde (36) métallisations comprend le dépôt des première et seconde métallisations d'une manière telle que ces métallisations soient alignées axialement avec les couches métalliques (31, 37) et aient une étendue latérale égale à l'étendue latérale de ces couches métalliques.

17. Le procédé selon la revendication 14, caractérisé par l'opération consistant à découper (64) avec un faisceau laser la plaque métallique (42) du premier élément tampon d'absorption des contraintes en cuivre structuré (12), d'une manière permettant l'enlèvement de la majeure partie de la région du premier élément tampon d'absorption des contraintes en cuivre structuré qui n'est pas liée à la tranche de dispositif semiconducteur (16) après chauffage de cette tranche.

18. Le procédé selon la revendication 17, caractérisé par l'opération d'attaque par pulvérisation cathodique de la surface de bord biseautée (16c) de la tranche de dispositif semiconducteur, après découpage de la plaque métallique.

19. Le procédé selon la revendication 18, caractérisé par l'opération consistant à passiver le bord biseauté après attaque par pulvérisation cathodique de ce bord biseauté.

20. Le procédé selon l'une quelconque des revendications précédentes, caractérisé en ce que la pression élevée est dans la plage d'environ 138 à 345 MPa.

21. Le procédé selon l'une quelconque des revendications précédentes, caractérisé par l'opération qui consiste à polir les première et seconde surfaces principales opposées avant de leur appliquer respectivement les première (21) et seconde (23) couches métalliques.

22. Le procédé selon l'une quelconque des revendications précédentes, caractérisé en ce qu'on effectue l'opération de polissage par un polissage mécanique des première et seconde surfaces principales opposées.

23. Le procédé selon l'une quelconque des revendications précédentes, caractérisé en ce qu'on effectue l'opération de polissage par attaque chimique des première et seconde surfaces principales opposées.

24. Presse (10) pour lier ensemble par diffusion les surfaces métalliques d'une structure comprenant une première plaque métallique (22) ayant un coefficient de dilatation thermique prédéterminé; une seconde plaque métallique (24) ayant un coefficient de dilatation thermique prédéterminé, cette seconde plaque étant orientée parallèlement à la première plaque et espacée par rapport à elle de façon à permettre la réception de la structure entre les première et seconde plaques; des moyens de support métalliques (26, 30) qui accouplent la première plaque à la seconde plaque, ces moyens de support ayant un coefficient de dilatation thermique sélectionne de façon à limiter leur dilatation à une valeur inférieure à la dilatation totale affectant l'épaisseur des première et seconde plaques lorsqu'on chauffe la presse à une température élevée; grâce à quoi on peut exercer des pressions égales sur les surfaces métalliques de la structure, pour comprimer ces surfaces ensemble avec une pression élevée lorsqu'on chauffe la presse à une température élevée; des premier (88) et second (90) blocs de dilatation placés face à face et fixés respectivement aux première et seconde plaques, ces premier et second blocs de dilatation comprenant respectivement des première (88a) et seconde (90a) parties surélevées qui s'étendent l'une vers l'autre, chaque partie surélevée comprenant une surface plane ayant une configuration géométrique sélectionnée, les configurations géométriques des première et seconde parties surélevées étant pratiquement identiques et alignées mutuellement axialement et en rotation, et chacune des surfaces planes étant pratiquement parallèle à l'autre.

25. La presse de la revendication 24, dans laquelle les premier (88) et second (90) blocs de dilatation sont fabriqués dans une matière ayant une coefficient de dilatation thermique égal au coefficient de dilatation thermique de la première plaque (22) et de la seconde plaque (24).

26. La presse selon les revendications 24 ou 25, caractérisé en ce que les premier (88) et second (90) blocs de dilatation sont fabriqués dans une matière ayant un coefficient de dilatation thermique supérieur au coefficient de dilatation themique de la première plaque (22) et de la seconde plaque (24).

27. La presse selon les revendications 24 ou 25 ou 26 caractérisé par des moyens de guidage (92) qui s'étendent à partir du premier bloc de dilatation (88) vers le bloc de dilatation (90), pour aligner axialement les première (88a) et seconde (90a) parties surélevées.

28. La presse selon la revendication 27, caractérisé en ce que les moyens de guidage comprennent un cylindre métallique (92) qui entoure les premier (88) et second (90) blocs de dilatation, en étant en contact avec ceux-ci.

29. La presse selon la revendication 28, caractérisé en ce que les moyens de guidage (92) sont fabriqués en un métal ayant un coefficient de dilatation thermique égal au coefficient de dilatation thermique des premier (88) et second (90) blocs.

30. La presse selon la revendication 28, caractérisé en ce que les moyens de guidage (92) sont fabriqués en un métal ayant un coefficient de dilatation thermique supérieure au coefficient de dilatation thermique des premier (88) et second (90) blocs.

**Revendications Pour l'Etat Contractant: CH**

1. Un procédé de liaison par diffusion par thermocompression d'un élément tampon d'absorption des contraintes en cuivre structuré (12) sur une tranche de dispositif semiconducteur sans substrat (16) ayant deux surfaces principales opposées, ce élément tampon d'absorption des contraintes comprenant un faisceau de brins de cuivre (40) serrés et pratiquement parallèles, de longueur pratiquement égale, dont une extrémité commune est liée par diffusion par thermo-compression à une plaque métallique (14), procédé caractérisé en ce qu'il comprend les opérations suivantes:

on applique une première couche métallique (21) sur l'une desdites surfaces principales;

on applique une seconde couche métallique (23) sur la première couche métallique;

on place l'extrémité commune des brins (40) de l'élément tampon d'absorption des contraintes (12) qui est opposée à la plaque métallique (14) contre la seconde couche métallique;

on entoure d'une atmosphère inerte la tranche de dispositif semiconducteur (16) et la mémoire tampon d'absorption des contraintes;

on applique une force destinée à comprimer ensemble avec un pression élevée la tranche de dispositif semiconducteur et l'élément tampon d'absorption des contraintes; et

on chauffe la tranche de dispositif semiconducteur et l'élément tampon d'absorption des contraintes à une température comprise dans la plage de 300°C à 400°C, pendant l'application de ladite force.

2. Un procédé selon la revendication 1, caractérisé par les opérations suivantes:

on applique respectivement des première (31) et seconde (32) couches métalliques sur les première (16a) et seconde (16b) surfaces principales opposées de la tranche de dispositif semiconducteur (16);

on applique respectivement des première (34) et seconde (36) métallisations sur les première et seconde couches métalliques;

on intercale la tranche de dispositif semiconducteur entre le premier élément tampon d'absorption des contraintes en cuivre structuré (12) et un second (74) avec la surface de chaque élément tampon d'absorption des contraintes en cuivre structuré qui est opposée à sa plaque métallique respective (42, 52) placée face à la tranche, chacun de ces éléments tampons d'absorption des contraintes en cuivre structuré ayant une étendue latérale supérieure à l'étendue latérale de la tranche de dispositif semiconducteur et étant placé de façon à surplomber la totalité de la surface de bord extérieure (16c) de la tranche de dispositif semiconducteur.

3. Un procédé selon les revendications 1 ou 2, caractérisé en ce qu'on positionne contre une surface de référence plane (20a) d'un élément rigide (20) la surface de la tranche de dispositif semiconducteur (16) qui est opposée à la surface de la tranche portant des première (21) et seconde (23) couches métalliques.

4. Le procédé des revendications 1 ou 3, caractérisé en ce que l'élément rigide (20) consiste en quartz.

5. Un procédé selon la revendication 1, caractérisé en ce que les première (16a) et seconde (16b) surfaces principales opposées ont des étendues latérales inégales et une surface de bord extérieure biseautée (16c); on revêt la surface biseautée avec une matière de passivation (82); on intercale la tranche de dispositif semiconducteur entre les premier (12') et second (74) éléments tampons d'absorption des contraintes en cuivre structuré, et en alignement axial avec ces éléments, chacun des éléments tampons d'absorption des contraintes en cuivre structuré ayant une étendue latérale au moins égale à l'étendue latérale de la surface latérale respective de la tranche de dispositif semiconducteur en contact avec lui, de façon que le bord biseauté ne soit recouvert par aucun des éléments tampons d'absorption des contraintes en cuivre structuré, l'extrémité commune des brins de cuivre (40', 50) de chacun des premier et second éléments tampons d'absorption des contraintes en cuivre structuré qui est opposée à la plaque métallique respective (42', 52) de cet élément étant positionnée face à la tranche de dispositif semiconducteur (16); on applique une force à des parties sélectionées des premier et second éléments tampons d'absorption des contraintes en cuivre structure, pour comprimer ensemble les premier et second éléments tampons d'absorption des contraintes en cuivre structuré et la tranche de dispositif semiconducteur, avec une pression élevée, la partie sélectionnée du premier élément tampon d'absorption des contraintes en cuivre structuré ayant une taille et une forme géométriques pratiquement identiques à celles de la partie sélectionnée du second élément tampon d'absorption des contraintes en cuivre structuré, et étant pratiquement alignée axialement et en rotation avec la partie sélectionnée du second élément tampon d'absortion des contraintes en cuivre structuré.

6. Le procédé de la revendication 5, caractérisé par l'opération qui consiste à placer des première (54) et seconde (56) couches de matière compressible non réactive en contact avec les plaques métalliques (42, 52) des premier (12) et second (74) éléments tampons d'absorption des contraintes en cuivre structuré respectifs, avant d'entourer d'une atmosphère inerte la tranche de dispositif semiconducteur (16) et les éléments tampons d'absorption des contraintes en cuivre structuré.

7. Un procédé selon la revendication 4, caractérisé en ce que la première surface principale (16a) est plus petite que la seconde surface principale (16b), le premier élément tampon d'absorption des contraintes en cuivre structuré (12') est situé sur la première surface et il a une étendue latérale qui n'est pas supérieure à l'étendue latérale de la première surface principale, et le second élément tampon d'absorption des contraintes en cuivre structuré (74) a une étendue latérale au moins égale à l'étendue latérale de la seconde surface.

8. Le procédé selon les revendications 1 ou 3 ou 4 ou 5, caractérisé en ce que la première couche métallique (21) est constituée par l'une des matières du groupe comprenant le titane, le chrome et le nickel, et la seconde couche métallique (23) est constituée par l'une des matières du groupe comprenant le cuivre, l'argent et l'or.

9. Le procédé selon les revendications 2 ou 5, caractérisé en ce que les première (31) et seconde (37) couches métalliques sont constituées par l'une des matières du groupe comprenant le titane, le chrome et le nickel, et les première (34) et seconde (36) métallisations sont constituées par l'une des matières du groupe comprenant le cuivre, l'argent et l'or.

10. Le procédé selon la revendication 4, caractérisé en ce qu'on chauffe l'élément rigide (20), la tranche de dispositif semiconducteur (16) et l'élément tampon d'absorption des contraintes (12) à environ 325°C pendant une durée dans la plage d'environ 15 minutes à 3 heures, pendant qu'on comprime ensemble l'élément rigide, la tranche de dispositif semiconducteur et l'élément tampon d'absorption des contraintes.

11. Le procédé selon les revendications 1 ou 3 ou 4 ou 5 ou 8, caractérise par l'opération consistant à placer une couche (32) de matière compressible non réactive contre la plaque métallique (14) de l'élément tampon d'absorption des contraintes en cuivre structuré (12), avant l'application de ladite force.

12. Le procédé selon la revendication 11, caractérisé en ce qu'on chauffe la couche (32) de matière compressible, l'élément rigide (20), la tranche de dispositif semiconducteur (16) et l'élément tampon d'absorption des contraintes (12) à environ 325°C pendant une durée comprise dans la plage d'environ 15 minutes à 3 heures, pendant qu'on comprime ensemble la couche de matière compressible, l'élément rigide, la tranche de dispositif semiconducteur et l'élément tampon d'absorption des contraintes.

13. Le procédé selon les revendications 1 ou 2 ou 9, caractérisé par l'opération consistant à positionner des première (54) et seconde (56) couches de matière compressible non réactive respectivement contre les plaques métalliques (42, 52) des premier (12) et second (74) éléments tampons d'absorption des contraintes en cuivre structuré, avant l'application de ladite force.

14. Le procédé selon la revendication 2, caractérisé par l'opération consistant à biseauter le bord extérieur de la tranche de dispositif semiconducteur, pour former une surface de bord biseautée (16c), avant d'intercaler la tranche de dispositif semiconducteur entre les premier (12) et second (74) éléments tampons d'absorption des contraintes en cuivre structuré, avec le premier éléments tampon d'absorption des contraintes en cuivre structuré placé face à la surface biseautée.

15. Le procédé selon la revendication 14, caractérisé en ce que l'opération qui consiste à appliquer les première (31) et seconde (37) couches métalliques comprend le depôt d'une première et d'une seconde couches métalliques ayant une étendue latérale inférieure à l'étendue latérale de la tranche (16), et suffisamment petites pour qu'elles ne recouvrent pas la surface biseautée (16c), ces première et seconde couches métalliques étant mutuellement alignées en direction axiale.

16. Le procédé selon la revendication 15, caractérisé en ce que l'opération qui consiste à appliquer les première (34) et seconde (36) métallisations comprend le dépôt des première et seconde métallisations d'une manière telle que ces métallisations soient alignées axialement avec les couches métalliques (31, 37) et aient une étendue latérale égale à l'étendue latérale de ces couches metalliques.

17. Le procédé selon la revendication 14, caractérisé par l'opération consistant à découper (64) avec un faisceau laser la plaque métallique (42) du premier élément tampon d'absorption des contraintes en cuivre structuré (12), d'une manière permettant l'enlèvement de la majeure partie de la région du premier élément tampon d'absorption des contraintes en cuivre structuré qui n'est pas liée à la tranche de dispositif semiconducteur (16) après chauffage de cette tranche.

18. Le procédé selon la revendication 17, caractérisé par l'opération d'attaque par pulvérisation cathodique de la surface de bord biseautée (16c) de la tranche de dispositif semiconducteur, après découpage la plaque métallique.

19. Le procédé selon la revendication 18, caractérisé par l'opération consistant à passiver le bord biseauté après attaque par pulvérisation cathodique de ce bord biseauté.

20. Le procédé selon l'une quelconque des revendications précédentes, caractérisé en ce que la pression élevée est dans la plage d'environ 138 à 345 MPa.

21. Le procédé selon l'une quelconque des revendications précédentes, caractérisé par

**0 025 057**

l'opération qui consiste à polir les première et seconde surfaces principales opposées avant de leur appliquer respectivement les première (21) et seconde (23) couches métalliques.

22. Le procédé selon l'une quelconque des revendications précédentes, caractérisé en ce qu'on effectue l'opération de polissage par un polissage mécanique des première et second surfaces principales opposées.

23. Le procédé selon l'une quelconque des revendications précédentes, caractérisé en ce qu'on effectue l'opération de polissage par attaque chimique des première et seconde surfaces principales opposées.

24. Presse (10) pour lier ensemble par diffusion les surfaces métalliques d'une structure comprenant une première plaque métallique (22) ayant un coefficient de dilatation thermique prédéterminé; une seconde plaque métallique (24) ayant un coefficient de dilatation thermique prédéterminé, cette seconde plaque étant orientée parallèlement à la première plaque et espacée par rapport à elle de façon a permettre la réception de la structure entre les première et seconde plaques; des moyens de support métalliques (26, 30) qui accouplent la première plaque à la seconde plaque, ces moyens de support ayant un coefficient de dilatation thermique sélectionné de façon à limiter leur dilatation à une valeur inférieure à la dilatation totale affectant l'épaisseur des première et seconde plaques lorsqu'on chauffe la presse à une température élevée; grâce à quoi on peut exercer des pressions égales sur les surfaces métalliques de la structure, pour comprimer ces surfaces ensemble avec une pression élevée lorsqu'on chauffe la presse à une température élevée; presse caractérisée en ce qu'elle comprend des première (88a) et seconde (90a) parties surélevées, comprises dans et s'étendant à partir de la première (22) et de la deuxième (24) plaques métalliques, respectivement l'une vers l'autre, chaque partie surélevée comprenant une surface plane ayant une configuration géométrique sélectionnée, les configurations géometriques des première et seconde parties surélevées étant pratiquement identiques et alignées mutuellement axialement et en rotation, et chacune des surfaces étant pratiquement parallèles à l'autre.

25. Presse selon la revendication 24, caractérisé en ce que le premier et le deuxième moyens de plaque comportent une première (22) et une deuxième (24) plaques, respectivement, et un premier (88) et une deuxième (90) blocs de dilatation placés face à face et fixés respectivement à la première et à la deuxième plaque, ces premiers et deuxième blocs de dilatation comprenant respectivement la première (88a) et la deuxième (90) parties surélevées.

26. La presse de la revendication 25, dans laquelle les premier (88) et second (90) blocs de dilatation sont fabriqués dans une matière ayant un coefficient de dilatation thermique égal au coefficient de dilatation thermique de la première plaque (22) et de la seconde plaque (24).

27. La presse selon les revendications 25 ou 26 caractérisé en ce que les premier (88) et second (90) blocs de dilatation sont fabriqués dans une matière ayant un coefficient de dilatation thermique supérieur au coefficient de dilatation thermique de la première plaque (22) et de la seconde plaque (24).

28. La presse selon les revendications 25 ou 26 ou 27, caractérisé par des moyens de guidage (92) qui s'étendent à partir du premier bloc de dilatation (88) vers la second bloc de dilatation (90), pour aligner axialement les première (88a) et seconde (90a) parties surélevées.

29. La presse selon la revendication 28, caractérisée en ce que les moyens de guidage comprennent un cylindre métallique (92) qui entoure les premier (88) et second (90) blocs de dilatation, en étant en contact avec ceux-ci.

30. La presse selon la revendication 29, caractérisé en ce que les moyens de guidage (92) sont fabriqués en un métal ayant un coefficient de dilatation thermique égal au coefficient de dilatation thermique des premiers (88) et second (90) blocs.

31. La presse selon la revendication 29, caractérisé en ce que les moyens de guidage (92) sont fabriqués en un métal ayant un coefficient de dilatation thermique supérieur au coefficient de dilatation thermique des premier (88) et second (90) blocs.

DRAWINGS for all Contracting States: CH DE FR GB SE

# FIG. 1

10  28  22  30
26
14
12  40
23
16  21
24  20a  20

# FIG. 2

10  28  30
22
26
32  14
12  40
23
16  21
24  20  20a

1

DRAWINGS for the Contracting States: DE FR GB SE

FIG. 3

FIG. 4

0 025 057

FIG. 3

FIG. 4

3

DRAWINGS for all Contracting States: CH DE FR GB SE

FIG. 5

FIG. 6

DRAWINGS for the Contracting States: DE FR GB SE

# FIG. 7

# FIG. 8

DRAWINGS for the Contracting State: CH

# FIG. 7

# FIG. 8

DRAWING for the Contracting State: CH

# FIG. 9